# EUROPEAN PATENT SPECIFICATION

(11) **EP 3 299 294 B1**
(45) Date of publication and mention of the grant of the patent: **28.10.2020**
(21) Application number: 17184132.3
(22) Date of filing: 31.07.2017
(51) Int. Cl.: B64D 15/08, G01F 1/58, G01R 33/12, G01S 17/00, F04F 5/24, B64D 15/20, G01S 17/42, G01S 17/88, G01S 7/499

(54) **SYSTEM AND METHOD FOR ANTI-ICING AN ICE PRONE SURFACE OF AN AIRCRAFT**
SYSTEM UND METHODE ZUR ENTEISUNG EINER VEREISUNGSGEFÄHRDETEN OBERFLÄCHE EINES FLUGZEUGS
SYSTÈME ET PROCÉDÉ DE DÉGIVRAGE D'UNE SURFACE D'AVION

(30) Priority: 22.09.2016 US 201662398382 P; 30.06.2017 US 201715639917
(43) Date of publication of application: 28.03.2018
(73) Proprietor: The Boeing Company, Chicago, IL 60606-2016 (US)
(72) Inventor: JACKOWSKI, Jason J., Chicago, IL 60606-1596 (US); MACKIN, Steve G., Chicago, IL 60606-1596 (US)
(74) Representative: Plasseraud IP

(56) References cited:
- WO-A1-99/16034
- GB-A- 2 130 158
- US-A- 5 523 959
- US-A- 5 921 501
- US-B1- 7 439 877

## Description

### BACKGROUND

The present disclosure relates to anti-ice systems, and more specifically, to anti-ice systems including sensors that sense the presence of ice protection fluid.

Ice buildup on aerodynamic surfaces of aircraft can be problematic. For example, ice can build up on the leading edges of wings and/or engine nacelles. The ice can also disrupt the intended airflow over the aerodynamic surfaces, causing a loss of lift generated by the aerodynamic surface. A combination of design considerations of modern airfoils and modern certification requirements result in less ice tolerance, meaning that modern aircraft need to have more anti-ice capability than some conventional anti-icing technologies can provide. However, existing anti-ice technologies are complicated and/or expensive.

Generally, aircraft with on-board anti-ice or de-ice capability use systems selected from bleed air systems, Tecalemit-Kilfrost-Sheepbridge (TKS) systems or Freezing Point Depressant (FPD) systems, and pneumatic/mechanical boots. FPD systems are considered the most energy efficient, using a glycol-based fluid that is wept onto the leading edge of an airfoil, an engine nacelle, and/or a spinner for a propeller or fan from a porous panel. The glycol-based fluid mixes with water droplets, lowering the freezing point of the water droplets so that the water droplets cannot freeze. The mixture of glycol-based fluid and water droplets then flow off the aircraft together.

Moreover, to verify the FPD system is functioning properly, a pre-flight inspection is performed with the system on. The system is activated and the porous panels are visually inspected to ensure fluid is flowing properly on all of the panels and all the right places. Visual human inspection is time consuming, messy, and difficult since the ice protected surfaces and porous panels are often far away from a mechanic on the ground and commercial aircraft are large. Moreover, commercial aviation ground crews are busy and adding a visual inspection task that entails activating a system in the cockpit is unacceptable.

What is needed, then, is a solution that indicates the functioning of the anti-ice system in a more efficient manner. The present disclosure satisfies this need.

Background art includes patent publications GB2130158A and US5523959A.

GB2130158A discloses a leading edge of an airfoil surface comprising a rigid self- supporting, porous, nonmetallic composite fabric material and is adapted for use with reservoir means for containing a fluid and means for pressurizing the fluid so as to cause it to flow over the outer surface thereof at a predetermined flow rate, means being provided for controlling the flow of pressurized fluid through the material to the outside surface. The flow controlling means is a microporous plastics membrane.

US5523959A discloses an ice detector and deicing fluid effectiveness monitoring system for an aircraft. The ice detection portion is suited for use in flight to notify the flight crew of an accumulation of ice on an aircraft lifting and control surfaces, or helicopter rotors, whereas the deicing fluid effectiveness monitoring portion is suited for use on the ground to notify the flight crew of the possible loss of the effectiveness of the deicing fluid. The ice detection portion comprises a temperature sensor and a parallel arrangement of electrodes whose coefficient of coupling is indicative of the formation of the ice, as well as the thickness of the formed ice. The fluid effectiveness monitoring portion comprises a temperature sensor and an ionic-conduction cell array that measures the conductivity of the deicing fluid which is indicative of its concentration and, thus, its freezing point. By measuring the temperature and having knowledge of the freezing point of the deicing fluid, the fluid effectiveness monitoring portion predicts when the deicing fluid may lose its effectiveness because its freezing point may correspond to the temperature of the ambient.

### SUMMARY

The present disclosure describes a system for anti-icing an ice-prone surface of an aircraft as defined by independent claim 1 and a method of anti-icing an ice prone surface of an aircraft as defined by independent claim 18.

In various examples, the anti-icing system is a Fluid Ice Protection System (FIPS) weeping out ice protection fluid onto ice-prone surfaces. The FIPS includes a porous panel having a weeping portion from which the ice-protection fluid weeps onto the ice-prone surface to remove or prevent ice build-up on the ice-prone surface.

The sensor comprises a Light Detection and Ranging (LIDAR) system emitting a LIDAR beam. The LIDAR system may include one or more transmitters transmitting the LIDAR beam and one or more receivers receiving the LIDAR beam. The transmitters and the receivers are mounted on the ice-prone surface or in the aircraft's fuselage. The LIDAR system may emit the LIDAR beam onto the ice prone surface and/or sweeps the ice-prone surface to measure the presence of the ice protection fluid.

According to one aspect of the LIDAR implementation, the ice protection fluid includes suspended particulates that reflect a specific wavelength of the LIDAR beam back to the LIDAR system, and detection of the specific wavelength by a receiver in the LIDAR system indicates the presence of ice protection fluid.

According to another aspect, the sensor is a metal detector. In one example, the metal detector includes a magnetic field sensor sensing a change in a magnetic field due to the metal particles added into the ice protection fluid. In yet a further example, the magnetic field sensor includes wire loops printed onto an inside of the porous panel, the wire loops sensing a change in the magnetic field.

According to yet another aspect, the sensor is a conductivity sensor comprising electrical contact pairs having their circuit closed when the ice protection fluid makes an electrical pathway between them. In one example, the electrical contact pairs measure impedance and/or voltage between two contact points on the ice-prone surface to differentiate the ice protection fluid from water flowing on the ice-prone surface.

The sensors are positioned at various locations on the aircraft. In one or more examples, the sensing elements are distributed on the ice-prone surface such that one or more of the following can be detected (1) blockage in the flow and the flow rate of the ice protection fluid, (2) weeping of the ice protection fluid from different sections of the porous panel and onto the ice prone surface, (3) unwanted leakage of ice protection fluid from the porous panel, and (4) functioning of the flow meter indicating flow of the ice protection system. In one example, the sensor includes sensing elements integrated on, and positioned downstream from, the weeping portion of the porous panel on the ice prone surface.

As indicated above, the ice protection fluid used in conjunction with the metal detector or the conductivity sensor has one or more properties that are sensed. In one example, metal particles, such as, but not limited to, iron, silver, or gold particles, are added to the ice protection fluid. In a further example, the metal particles are added in the form of a ferrofluid. In yet another example, the metal particles are nanoparticles distributed homogenously in the ice-protection fluid.

In another aspect, an alert system is activated when the anti-icing system is activated and the sensor does not detect the ice-protection fluid to a target level within a specified period of time, so that a non-icing flight condition can be found.

In yet another aspect, an eductor is used to evacuate ice protection fluid from the porous panel using engine bleed air when an unwanted leakage is detected by the sensor.

### BRIEF DESCRIPTION OF THE SEVERAL VIEWS OF THE DRAWINGS

Referring now to the drawings in which like reference numbers represent corresponding parts throughout:
FIG. 1A is a cross-sectional schematic illustrating a LIDAR system installed on an ice prone leading edge according to various aspects.
FIG. 1B illustrates suspended particulates added to the ice protection fluid, for use with a LIDAR sensor embodiment.
FIG. 2 is a schematic of a LIDAR system installed to sweep an ice-prone engine inlet according to various aspects.
FIG. 3 is a schematic of a LIDAR system installed to sweep an ice-prone wing leading edge according to various aspects.
FIG. 4A illustrates metal particles added to the ice protection fluid, for use with a metal detector or conductivity sensor embodiment.
FIG. 4B is a cross-sectional schematic illustrating metal detector sensors mounted at locations (e.g., 360 degrees) around an engine inlet according to various aspects.
FIG. 5 is a cross sectional schematic illustrating a metal detection device connected to the sensors on an engine inlet and outputting a flow detection signal to a FIPS control system according to various aspects.
FIG. 6A is a cross-sectional schematic of a conductivity sensor mounted on an ice prone leading edge according to various aspects.
FIG. 6B is a schematic of contact points on the conductivity sensor according to various aspects.
FIG. 7A is a schematic of a turbofan engine FIPS according to various aspects.
FIGs. 7B-7C is a schematic of a 3-way two position solenoid valve used in the FIPS of FIG. 7A according to various aspects.
FIG. 7D is an illustration of filling the tank of the FIPS according to various examples.
FIG. 7E is an illustration of charging the panels of the FIPS according to various examples.
FIG. 7F is an illustration of the operation of the FIPS during non-icing conditions, according to various examples.
FIG. 7G is an illustration of the operation of the FIPS during icing conditions, according to various examples.
FIG. 7H is an illustration of the operation of the FIPS during non-icing conditions after landing, according to various examples.
FIG. 7I is an illustration of integration of FIPS on an engine inlet, according to various examples.
FIG. 7J illustrates the position of the tank looking aft at the engine inlet, according to various examples.
FIG. 8 is a front perspective view of a gas turbine engine and an engine nacelle with an anti-ice system according to various aspects.
FIG. 9 is a front perspective view of a propeller and propeller spinner with an anti-ice system according to various aspects.
FIG. 10 is a top schematic view of an aircraft with an anti-ice system according to various aspects.
FIG. 11 is a flow chart illustrating a method for using an anti-ice system according to various aspects.
FIG. 12 is an illustration of anti-ice bleed air systems using thermal energy from the bleed air to melt ice on the engine.
FIG. 13 is a diagrammatic representation of a LIDAR device used in one or more embodiments. FIG. 14 is a flowchart illustrating ice detection processing operations according to one or more embodiments.
FIG. 15A-15B illustrate a diagrammatic representation of transforming a deformed shape into a common reference frame, according to one or more embodiments.
FIG. 16A is a schematic side view showing of positioning of LIDAR devices according to one or more embodiments.
FIG. 16B is a schematic cross-section showing positioning of LIDAR devices according to one or more embodiments.
FIG. 17 is a schematic cross-section showing light pulses swept in line patterns to measure cross-sections of the aerodynamic surface according to one or more embodiments.
FIG. 18 shows installation of a LIDAR system to measure ice on an ice-prone wing leading edge according to various examples.
FIG. 19 illustrates installation of a LIDAR system to measure ice on an ice-prone engine inlet, according to various examples.
FIG. 20 illustrates a front view of a LIDAR system on a two axis mount, according to various examples.
FIG. 21 illustrates a side view of the LIDAR system in FIG. 3 showing installation of the LIDAR system behind an aircraft window, according to various examples.
FIG. 22 is a schematic illustrating incident angles used in one or more embodiments.
FIG. 23A-23C is a schematic illustrating measuring ice thickness according to one or more embodiments.
FIG. 24 illustrates a processing environment for processing data from the sensors and/or activating the anti-ice system.

### DETAILED DESCRIPTION

In the following, reference is made to particular aspects presented in this disclosure. However, the scope of the present disclosure is not limited to specific described aspects. Instead, any combination of the following features and elements, whether related to different aspects or not, is contemplated to implement and practice contemplated aspects. Furthermore, although aspects disclosed herein may achieve advantages over other possible solutions or over the prior art, whether or not a particular advantage is achieved by a given aspect is not limiting of the scope of the present disclosure. Thus, the following aspects, features, and advantages are merely illustrative and are not considered elements or limitations of the appended claims except where explicitly recited in a claim(s).

In aspects described herein, a system for anti-icing a surface (e.g., an aerodynamic surface) of an aircraft is disclosed. The system includes a sensor to indicate presence of ice protection fluid on the surface of the aircraft. The system further includes a anti-icing system on the surface thereafter regulating flow of the ice protection fluid on the surface based on input from the sensor regarding the presence of the ice-protection fluid. In various examples, the aerodynamic surface includes, but it not limited to, a tail, a wing, an engine inlet, or a windshield of an aircraft.

### ICE PROTECTION FLUID DETECTION EMBODIMENTS

### LIDAR Example

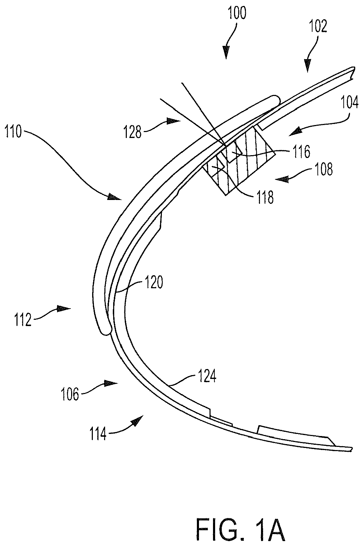

FIG. 1A illustrates a system 100 for anti-icing an ice-prone surface 102 of an aircraft 204, comprising a sensor 104 and an anti-icing system 106. The sensor 104 includes a LIDAR system 108 indicating presence of ice protection fluid 110 on the ice prone surface 102, wherein the ice prone surface 102 is a leading edge 112 of an aerodynamic surface 114 (e.g., engine inlet on an aircraft nacelle). The LIDAR system 108 includes one or more transmitters 116 and one or more receivers 118 flush mounted at (e.g., one or more key points) along the ice-prone surface 102. FIG. 1A further illustrates the anti-icing system 106 includes a porous panel 122 on the leading edge 112. The porous panel 120 (e.g., porous plastic) has an outer skin 122 and an inner skin 124. The outer skin 122 is laser drilled with pores over an active area. The ice protection fluid 110 with weeps out of from the pores on the leading edge 112 of the outer skin 122. The anti-icing system 106 on the ice-prone surface 102 regulates flow rate of the ice protection fluid 110 on the ice prone surface 102 based on input from the sensor 104 regarding the presence of the ice-protection fluid 110.

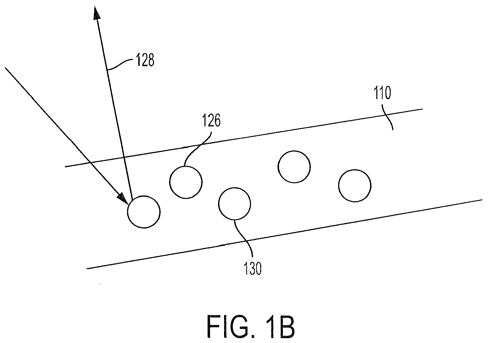

FIG. 1B illustrates suspended particulates 126 are added to the ice protection fluid 110. The suspended particles 126 reflect a specific and/or known wavelength of a LIDAR beam 128 when excited by the LIDAR beam 128 emitted from the one or more transmitters 116. Detection of the specific and/or known wavelength by the one or more receivers 118 in the LIDAR system 108 detects the particulates 126 in the ice protection fluid 110 thereby indicating the presence of ice protection fluid 110.

In one or more examples, the LIDAR system 108 is a device wholly contained in one unit where the particles 126 are detected. In various other examples, the transmitter 116 and receiver 118 are located on the aerodynamic surface 114 and the computational component and/or laser generator for the LIDAR system 108 are located elsewhere.

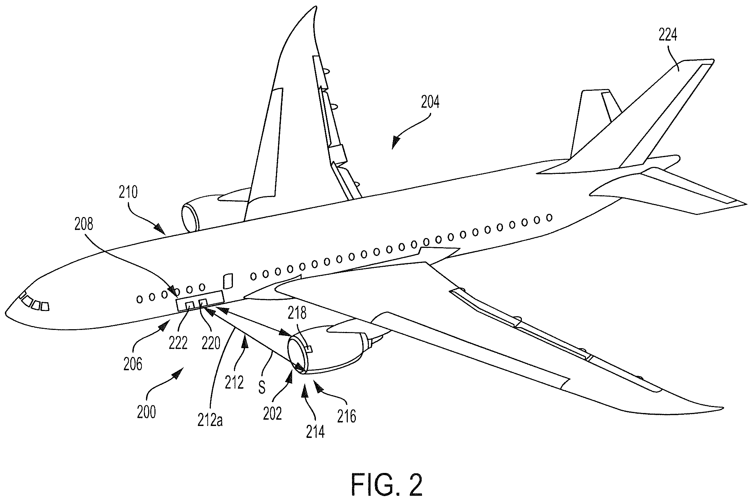

FIG. 2 illustrates another system 200 for anti-icing an ice-prone surface 202 of an aircraft 204, comprising a sensor 206 including a LIDAR system 208 mounted in the aircraft's 204 fuselage 210. The LIDAR system 208 emits the LIDAR beam 212 sweeping S the ice-prone surface 202 of an engine inlet 214 (of a nacelle 216) to measure the presence of the ice protection fluid 218 on the ice prone surface 202 and determine if the ice protection fluid 218 is flowing on the ice prone surface 202. The LIDAR beam 212 detects the presence of the ice protection fluid 218 by measuring the presence of the particles 126 in the ice protection fluid 218 from the LIDAR beam's 212 backscatter 212a. The LIDAR system 208 comprises a transmitter 220 transmitting the LIDAR beam 212 and a receiver 222 receiving the backscatter 212a of the LIDAR beam 212 off the ice prone surface 202.

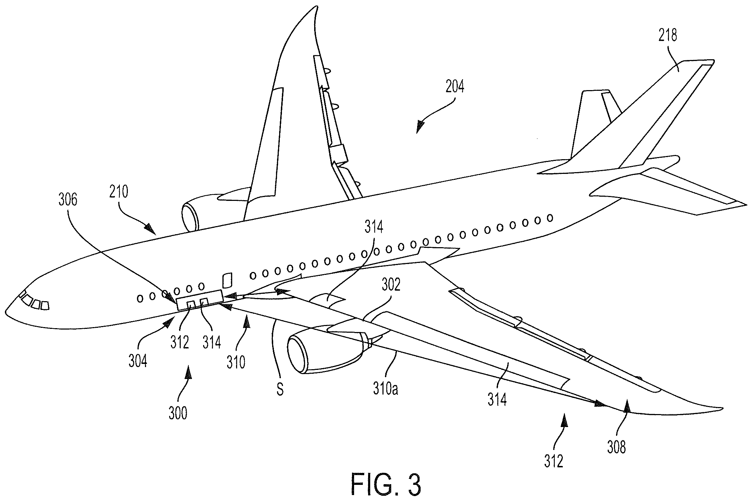

FIG. 3 illustrates another system 300 for anti-icing an ice-prone surface 302 of an aircraft 204, comprising a sensor 304 including a LIDAR system 306 mounted in the aircraft's 204 fuselage 210, wherein LIDAR system 306 emits the LIDAR beam 310 sweeping S the ice-prone surface 302 of a wing leading edge 312, to measure the presence of the ice protection fluid 314 and determine if the ice protection fluid 314 is flowing on the ice prone surface 302 of the wing 308. The LIDAR system 306 has a longer focal length than the LIDAR system 108 illustrated in FIG. 1B. The LIDAR beam 310 detects the presence of the ice protection fluid 314 by measuring the presence of the particles 126 in the ice protection fluid 314 from the LIDAR beam's backscatter 310a. The anti-icing system 314 on the ice-prone surface 302 regulates flow rate of the ice protection fluid 314 on the ice prone surface 302 based on input from the sensor 304 regarding the presence of the ice-protection fluid 314.

In one example, if the anti-ice system 106, 314 is activated and the LIDAR system 108, 306 does not detect the suspended particulates 126 within a specified time, the LIDAR system 108, 306 sends the flight crew a warning and the crew can then try to find non-icing flight conditions. In one example, the warning is an EICAS message.

### Metal Detector Example

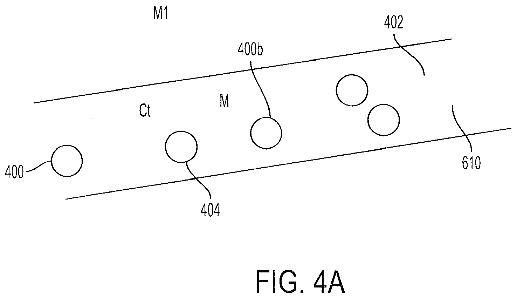

In a metal detector example, metal particles 400 are added to the ice protection fluid 402, as illustrated in FIG. 4A, and the sensor is a metal detector sensing flow of the metal particles in the ice-protection fluid.

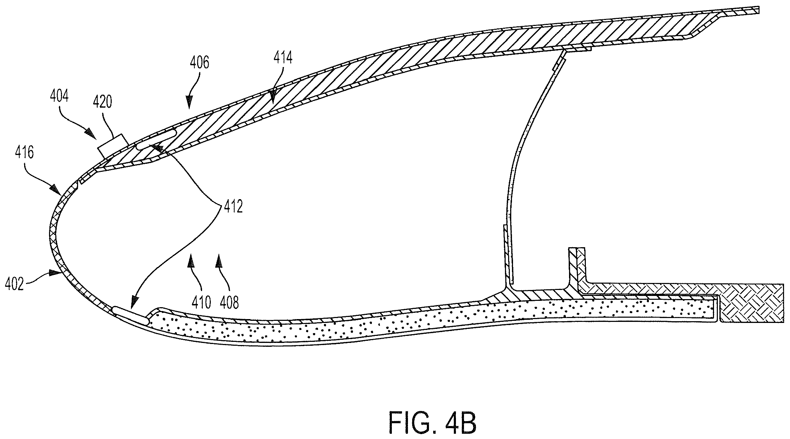

FIG. 4B illustrates a system 404 for anti-icing an ice-prone surface 406 of an aircraft 204, comprising a sensor 408, wherein the sensor 408 is a metal detector 410 including sensing elements 412 integrated on a panel 414 on the ice-prone surface 406. In various examples, the sensors 412 are at locations 360 degrees around an engine inlet 214. The anti-ice system 416 includes the panel 414 having a weeping portion (a porous panel 418) from which the ice-protection fluid 402 weeps or is distributed onto the ice-prone surface 406 to remove or prevent ice build-up 420 on the ice-prone surface 406. The sensing elements 412 are positioned downstream from the porous panel 418. Metal particles 400 are added to the ice protection fluid 402 and the metal detector 410 senses flow of the metal particles 400 in the ice-protection fluid 402. In one example, the metal detector 410 includes a magnetic field sensor sensing a change in a magnetic field due to the metal particles 400. In another example, the sensing elements 412 are wire loops printed onto an inside of the panel 414 and the wire loops sense a change in magnetic field due to flow of the metal particles 400 (e.g., iron particles) in the ice protection fluid 402.

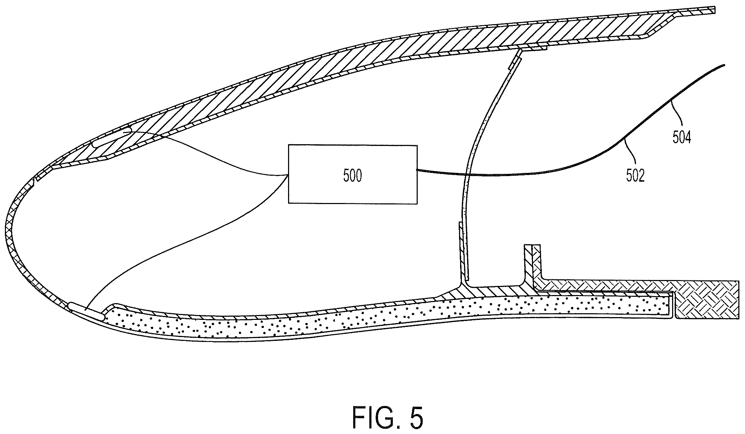

FIG. 5 illustrates an example wherein the sensing elements 412 are connected to a metal detection device 500. When the ice protection fluid 402 is flowing over the sensing elements 410 (e.g., wire loops), the sensing elements 412 output detection signals to the metal detection device 500 indicating the presence of a moving particle 400. The metal detection device 500 then outputs a flow detection signal 502 through wires 504 to the anti-icing system 424 verifying whether the anti-icing system 416 is functioning properly. In various examples, the flow detection signal 502 is outputted to a FIPS control system.

### Conductivity Detector Example

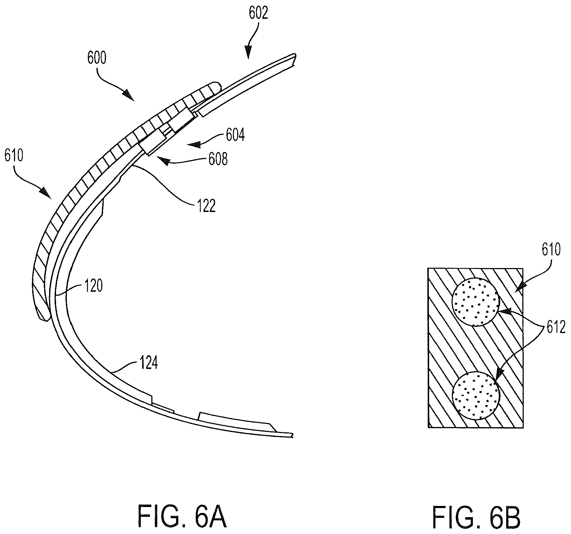

FIG. 6A and FIG. 6B illustrate an example system 600 for anti-icing an ice-prone surface 602 of an aircraft 204, comprising a sensor 604 and an anti-ice system 606, wherein the sensor 604 includes one or more electrical contact pairs 608 having their circuit closed when the ice protection fluid 610 makes an electrical pathway between them. The one or more contact pairs 608 each include contact points 612 on the ice prone surface 602. A voltage and/or impedance measuring device is used to measure impedance and/or voltage between two contact points 612 on the ice-prone surface 602, thereby determining if the ice protection fluid 610 is covering the ice-prone area and/or weeping out of the porous panel 122 on the leading edge 112 of the aerodynamic surface 614. In one instance, several of the contact pairs 608 are distributed on critical ice-prone areas to adequately determine if the anti-icing system 606 (ice protection system) is working. In another example, the impedance and/or voltage between the contact points 612 is measured by the electrical contact pairs 608 to differentiate the ice protection fluid 610 from water flowing on the ice-prone surface 602. In yet another example, the ice protection fluid 610 includes metal particles 400b (e.g., ferro-fluid particles) that increase conductivity of the ice-protection fluid 610. The use of ferro-fluid is useful if the contact points 612 are not very sensitive or the conductivity sensor 604 would otherwise have difficulty distinguishing between water and the ice protection fluid 610.

Thus, FIGs.4A, 4B, 5, 6A-6C illustrate a sensor 408, 604 indicating presence of ice protection fluid 402, 610, on an ice prone surface 406, 602 of an aircraft 204; and an anti-icing system 416, 606 on the ice-prone surface 406, 602 regulating flow rate of the ice protection fluid 402, 610 on the ice prone surface 406, 602 based on input from the sensor 408, 604 regarding the presence of the ice-protection fluid 402, 610.

### Example fabrication

In various aspects, the ice protection fluid includes anti-freeze, anti-ice fluid, or anti-icing fluid, which are defined as fluids that remove or prevents build up of ice. An example of such a fluid, includes, but is not limited to, a glycol based fluid.

In various aspects, the ice protection fluid is combined with an additive, wherein the additive modifies a conductivity and/or a magnetic property of the ice protection fluid such that a presence of ice protection fluid can be sensed.

In one example, a method of fabricating the ice protection fluid used with the metal detector and the conductivity detector comprises seeding the ice protection fluid with metal particles, including, but not limited to, iron, silver, and gold. As used herein, metal particles include, but are not limited to, nanoparticles, nanosized particles, or microparticles. In one example, the fabrication comprises adding a quantity of ferrofluid (including, e.g., ferrous particles) to the ice protection fluid. In one instance, the method further comprises mixing the ice protection fluid until the ice protection fluid is homogenized. Homogenization ensures the nanoparticles are suspended throughout the ice protection fluid.

In various aspects, one or more metal detectors are printed onto a surface below the flowing ice protection fluid to detect the ice protection fluid seeded with metal particles flowing over the metal detectors. In one example, small (e.g., smaller than a dime but bigger than a diameter of a push pin) loops of wire are printed onto/inside the porous panel to form the magnetic sensors._In one or more examples, Direct-Write technology is used to print the detectors (e.g., wire loops).

In a further example, pure ferrofluid is inserted into the porous panel and the ferrofluid is sensed using the sensors to check the functioning of the sensor.

### EXAMPLE ANTI-ICING SYSTEMS

### First Example

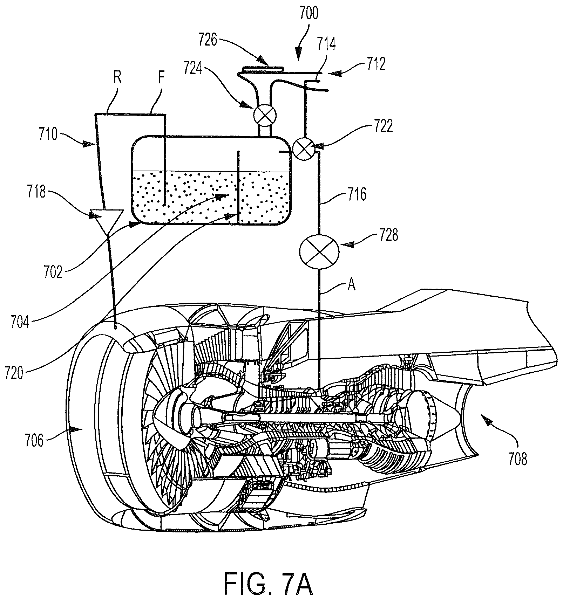

FIG. 7A illustrates a FIPS 700 including a tank 702 containing ice protection fluid 704; a porous panel 706 including a porous lip skin of an engine inlet on a turbofan engine 708; a conduit 710, such as a fluid pick up line; and an eductor 712.

In various examples, the porous lipskin comprises a porous membrane.

The conduit 710 delivers the ice protection fluid 704 from the tank 702 to the porous panel 706 under pressure from engine bleed air when the tank 702 is pressurized by the engine bleed air. In one instance, the tank 702 is a pressurized composite tank. The conduit 710 extracts the ice protection fluid 704 from the porous panel 706 into the tank 702 under suctioning from the eductor 712 when the eductor 712 is connected to the tank 702 and the engine bleed air flows through a nozzle 714 (e.g., the bleed air flows supersonically through the nozzle) in the eductor 712. In various examples, the conduit 710 is a plastic tube.

The system further includes a second conduit 716 delivering the engine bleed air A from the high pressure compressor in the engine 708. In various examples, the engine bleed air is obtained from a bleed air system such a manifold. In various examples, the second conduit 716 is a stainless steel pipe. In various examples, the stainless steel pipe has a 3/8 inch diameter.

The system further includes a flow meter 718 (measuring flow rate of the ice protection fluid 704 in the conduit 710) and a fluid level sensor 720. In one example, the flow meter 718 is a displacement flow meter. In various examples, the ice protection fluid flows to the porous panel in the conduit comprising multiple fluid pick up lines and multiple flow meters.

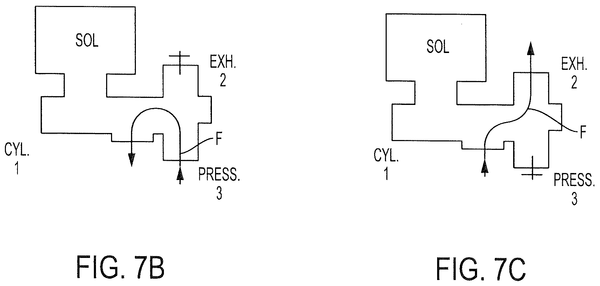

The system further includes a first valve 722 switching the flow of the engine bleed air between the tank 702 and the eductor 712 and a second valve 724 regulating the flow of the ice protection fluid between the tank 702 and the eductor 712. In one instance, the valves 722-724 are solenoid valves. In another instance, the first valve 722 is a three way two position solenoid (SOL) valve as illustrated in FIG. 7B and the second valve 724 is a solenoid on/off valve.

FIGs. 7B-7C illustrate operation of an example normally open solenoid on/off valve 724. When the solenoid (Sol) is de-energized, pressure (press) from the engine bleed air allows the engine bleed air to flow F through the valve cylinder (cyl) to the first valve 722 (FIG. 7B). When the solenoid (Sol) is energized, pressure (press) from the engine bleed air is blocked and cannot enter the cylinder (cyl) and flow in the second conduit 716 is connected to an exhaust (exh) (FIG. 7C).

Ice protection fluid 704 is replenished through a fill cap 726 on the eductor 712.

The system further includes a third valve 728 regulating the flow of the engine bleed air into the tank (e.g., using pressure). In one example, the valve is a pressure regulating shut off valve (PRSOV).

### Filling the tank

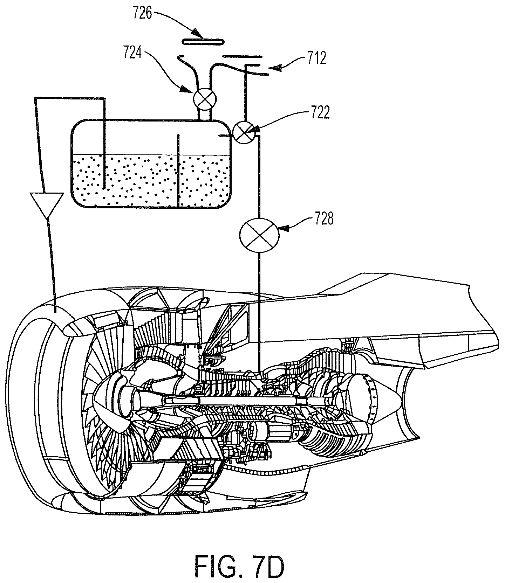

FIG. 7D illustrates the FIPS operating to fill the tank 702 with anti-ice fluid. The fill cap 726 is off, the second valve 724 is open, the third valve 728 is closed (closing off the engine bleed air), and the first valve 722 is switched to open the second conduit to the eductor. Anti-ice fluid is poured into the tank through the second valve. The eductor 712 is off.

### Charging Panels

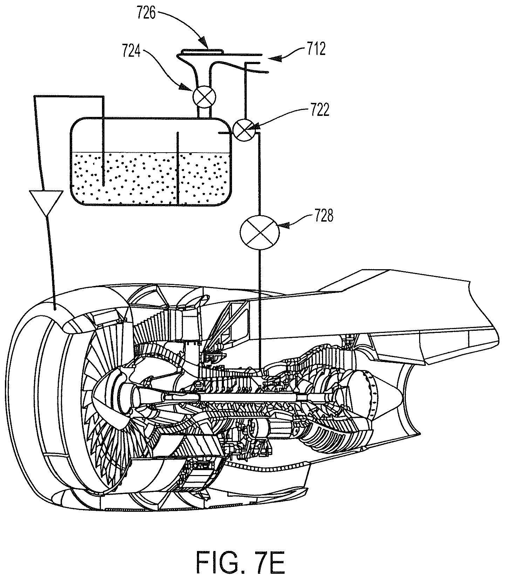

FIG. 7E illustrates the FIPS operating to charge the porous panels after starting the engine. The system is run in this mode until the porous panel in the engine lip is charged. The fill cap 726 is closed, the second valve 724 is closed, the third valve 728 is open (regulating the flow of engine bleed air during starting), and the first valve 722 is switched to open the second conduit 716 to pressurize the tank with the engine bleed air. The second conduit 716 delivers the engine bleed air from the high pressure compressor in the engine 708 to pressurize the tank and the conduit 710 delivers the ice protection fluid 704 from the tank 702 to the porous panel 706 under pressure from the engine bleed air. The eductor 712 is off.

### Operation in non-icing conditions

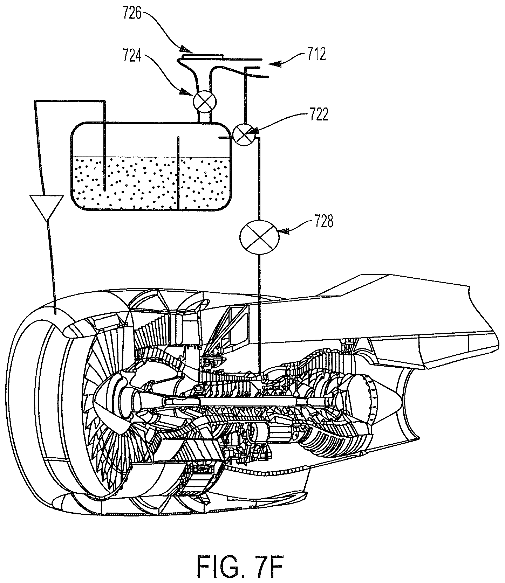

FIG. 7F illustrates the FIPS operating in a non-icing condition. The fill cap 726 is closed, the second valve 724 is closed, the third valve 728 is closed (closing off the engine bleed air while the engine is running), and the first valve 722 is switched to open the second conduit to the eductor. The eductor 712 vents leakage in the third valve 728 (third valve 728 is closed and the engine 708 is running).

### Operation in icing condition

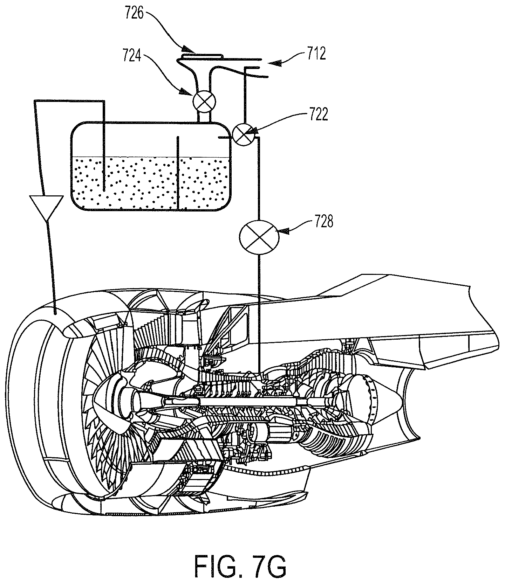

FIG. 7G illustrates the FIPS operating in an icing condition during flight or on the ground. The fill cap 726 is closed, the second valve 724 is closed, the third valve 728 is open (regulating the flow of engine bleed air to achieve fluid flow rate while the engine 708 is running), and the first valve 722 is switched to open the second conduit to pressurize the tank with the engine bleed air. The conduit 710 delivers the ice protection fluid from the tank to the porous panel under pressure from the engine bleed air. The eductor 712 is off. Ice protection fluid is flowing to the lip 706 through one or more pick up lines 710 and one or more flow meters 718.

### Operation in non-icing condition after landing

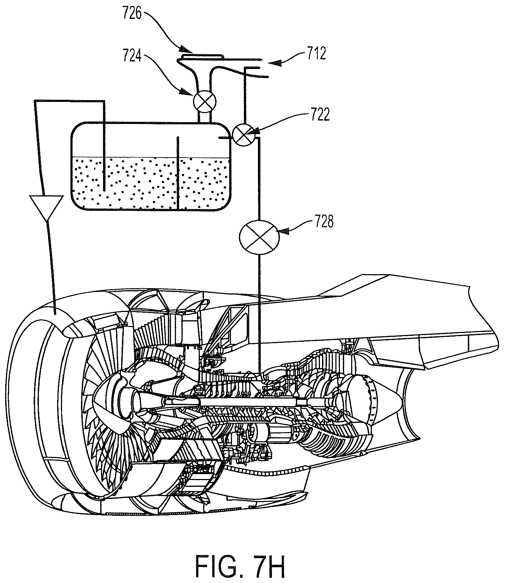

FIG. 7H illustrates the FIPS operating after touch down in a non-icing condition. The fill cap 726 is closed, the second valve 724 is open, the third 728 valve is open (regulating the engine bleed air to choke the eductor 712), and the first valve 722 is switched to open the second conduit 716 to the eductor. The conduit 710 extracts the ice protection fluid from the porous panel into the tank 702 under suctioning from the eductor 712 (eductor 712 on). The system is run in this mode until the fluid flow meter stops indicating flow.

### FIPS engine inlet integration

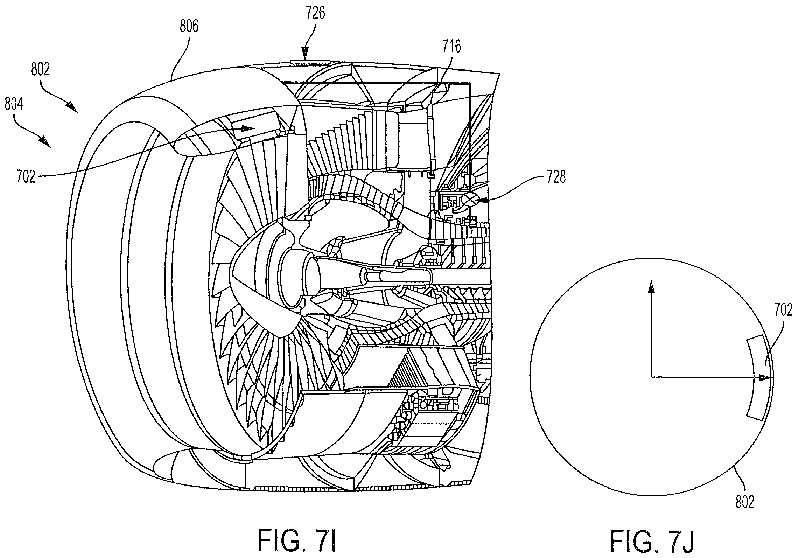

FIG. 7I shows the integration of a FIPS with the engine inlet lip 800 defining a leading edge of a nacelle 802 of an aircraft engine 804. The anti-ice fluid 704 is pumped into the leading edge cavity (comprising pressurized composite tank 702) and secreted through the inlet lip 800 having porous panel comprising a porous metallic lipskin 806. The action of the freestream airflow causes the fluid 704 to run back on both the internal and external surfaces of the inlet, protecting the full leading edge and preventing the formation of run back ice. FIG. 7J illustrates the position of the tank 702 looking aft at the engine inlet, wherein the tank is positioned at 90 degrees from the top of the engine inlet.

### Second Example: Porous panel on and engine inlet.

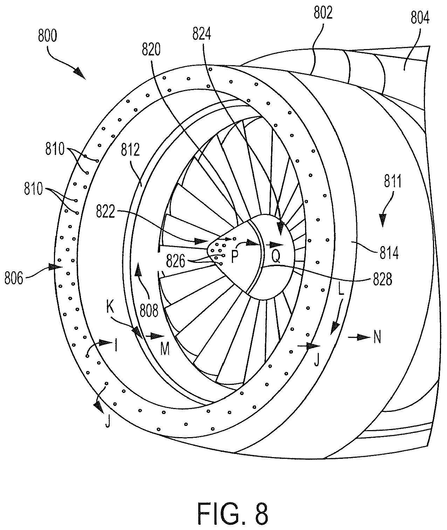

FIG. 8 illustrates an anti-ice system according to various aspects on a gas turbine engine 800. The gas turbine engine includes a nacelle 802 mounted on a pylon 804. The pylon 804 could connect the nacelle 802 to a wing or fuselage of an aircraft, for example. The nacelle 802 includes a leading edge 806. The leading edge 806 includes a porous panel including a plurality of orifices 810, through which an ice protection fluid can weep out. The ice protection fluid weeping out of the orifices 810 can travel in the direction of arrow I toward an inward-facing downstream surface 808 of the nacelle 802 or in the direction of arrow J toward an outward-facing downstream surface 811 of the nacelle 802. The inward-facing downstream surface 808 of the nacelle 802 includes an aperture 812. The aperture 812 could be arranged as a continuous aperture or as a series of spaced-apart apertures. Ice protection fluid traveling toward the aperture 812 can be drawn into the aperture 812 in the direction of arrow K and water carried by the ice protection fluid can continue into the engine in the direction of arrow M. The outward-facing downstream surface 811 of the nacelle 802 includes an aperture 814. The aperture 814 could be arranged as a continuous aperture or as a series of spaced-apart apertures. Ice protection fluid traveling toward the aperture 814 can be drawn into the aperture 814 in the direction of arrow L and water carried by the ice protection fluid can continue aft in the direction of arrow N.

A spinner 820 for the gas turbine engine 800 can also include an anti-ice system. An array of orifices 826 for weeping the ice protection fluid onto the spinner, can be arranged on a first region 822 (e.g., an upstream region) of the spinner 820. An aperture 828 can be arranged on a second region 824 (e.g., a downstream region) of the spinner 820. The aperture 828 could be arranged as a continuous aperture or as a series of spaced-apart apertures. Ice protection fluid traveling from the orifices 826 (in the direction of arrow O) toward the aperture 828 can be drawn into the aperture 828 in the direction of arrow P and water carried by the ice protection fluid can continue into the engine in the direction of arrow Q.

In one or more examples, the engines used with the ice protection system (including the sensor for the ice protection fluid) are smaller and more efficient, thereby enabling more efficient and lighter aircraft. One or more examples of the ice protection system enable the use of engines with very high bypass ratios and small cores because anti-ice bleed flow is reduced or eliminated.

### Third Example: Porous panel on a propeller or jet engine fan

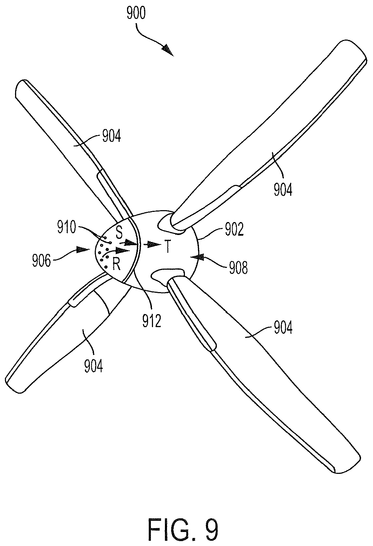

FIG. 9 illustrates an anti-ice system according to various aspects on an aircraft propeller 900. The propeller includes four propeller blades 904 extending from a spinner 902. An anti-ice system can be arranged for the spinner 902. An array of orifices 910, can be arranged on a first region 906 (e.g., an upstream region) of the spinner 902. An aperture 912 can be arranged on a second region 908 (e.g., a downstream region) of the spinner 902. The aperture 912 could be arranged as a continuous aperture or as a series of spaced-apart apertures. Ice protection fluid traveling from the orifices 910 (in the direction of arrow R) toward the aperture 912 can be drawn into the aperture 912 in the direction of arrow S and water carried by the ice protection fluid can continue toward the blades 904 the direction of arrow T.

In various examples, geared turbofan engines have fans that don't spin very fast. At some point they may spin slow enough that ice can form near the hub of the blade and an anti-ice system can be used to remove ice from the hub.

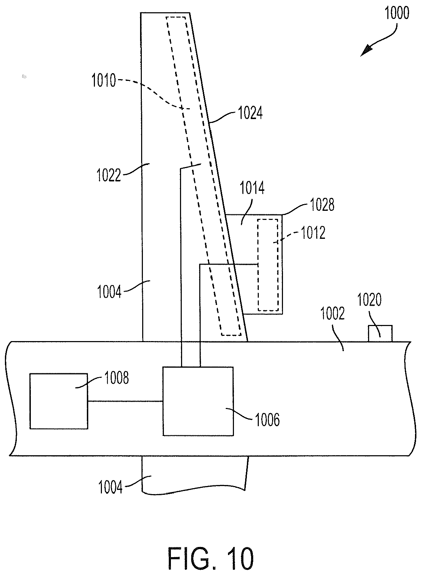

FIG. 10 is a schematic view of an aircraft 1000, illustrating a portion of the fuselage 1002 and the wings 1004 of the aircraft 1000. The aircraft includes a reservoir 1006 of ice protection fluid. The ice protection fluid can be provided to an anti-ice system 1010 (including porous panel) in/on the wings 1004 of the aircraft 1000 and to an anti-ice system 1012 in/on engines 1014 of the aircraft 1000. The anti-ice system 1010 in the wings 1004 could draw ice protection fluid from the reservoir 1006, pass the ice protection fluid through orifices in a leading edge of the wing, recover at least some of the ice protection fluid through apertures in a downstream region of the wing, and return the ice protection fluid to the reservoir 1006.

In various aspects, the aircraft 1000 includes an icing detector 1020. The icing detector 1020 could be a sensor that detects the buildup of ice thereon. In various aspects, computer systems onboard the aircraft 1000 could monitor the icing detector 1020 and automatically activate the anti-icing systems 1010 and 1012 if icing and/or icing conditions are detected.

In various aspects, the computer systems 1008 (including processors) are communicatively connected to the flow meter and valve controlling the flow of the engine bleed air into the tank, wherein the one or more processors use the flow rate of the ice protection fluid to control the flow rate of the engine bleed air through the valves such that the porous panels are charged with ice protection fluid after starting the engine. In various aspects, the one or more processors use the flow rate of the anti-icing fluid to control the flow rate of the engine bleed air such that the ice protection fluid flows out of the porous panels onto the aerodynamic surface, removing and preventing ice build-up on the aerodynamic surface.

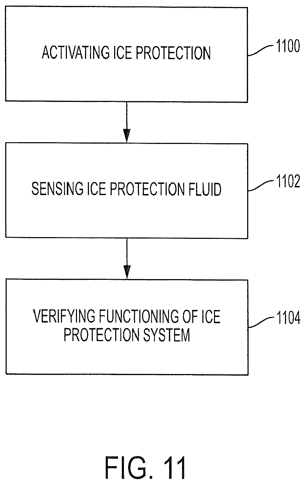

FIG. 11 is a flow chart that illustrates a method for operating an anti-ice system 106, 416 and detecting ice protection fluid 110, 402 on an aerodynamic surface 114, 1022 including, but not limited to, a wing 308, 1004 leading edge 1024, windshield, engine inlet 214, propeller 900, or tail 224 on an aircraft 1000 such as a civil aviation aircraft.

Block 1100 represents activating an ice protection system 106, 416 delivering ice protection fluid 110, 402 to the ice prone surface 102, 202 of the aerodynamic surface 114., 1022.

Block 1102 represents sensing a presence of the ice protection fluid 110, 402 and/or an additive 130, 404 in an ice protection fluid 110, 402 on the ice-prone surface 102, 202. In various examples, sensing the additive 130, 404 indicates a presence of ice protection fluid 110, 402 on the ice-prone surface 102, 202. In one example, the additive includes suspended particulates 126, 400, 400b that reflect a specific wavelength of a LIDAR beam 128 back to a LIDAR system 108, so that the LIDAR system 108 measures the presence of the ice protection fluid 110, 402. In another example, the sensing detects a conductivity C and/or a magnetic property M of the ice protection fluid 110, 402 to indicate presence of the ice protection fluid 110, 402. The ice protection fluid 110, 402 includes metal particles 400, 400b that modify a conductivity C and/or a magnetic property M of the ice protection fluid 110, 402, wherein the sensor indicates the presence of the ice protection fluid 110, 402 by sensing a change in conductivity C and/or magnetic field M1 measured by the sensor. In one example where the metal particles 400, 400b are iron particles, a magnet is used to detect the fluid. In another example where the particles 400, 400b are made of other metals, such as, but not limited to, silver or gold, a metal detector 410 is used to sense the particles 400 and detect the ice protection fluid 402.

In various examples, the sensor emits and senses RADAR, Microwave, or Millimeter Wave signals S. Some wavelengths can punch through moisture better, or allow for different antennas/detectors. For instance, millimeter wave reflectors could be applied to the protected surface or an ice prone surface 102, 202. When the fluid 110, 402 is flowing, the fluid (e.g., ice protection fluid 110, 402) disrupts the reflectors so the return signal to a transceiver is knocked way down.

Block 1104 represents using the sensor 104, 408, 604 output to indicate, determine, or verify whether the anti-ice or ice protection system 106, 416 is functioning properly and applying ice protection fluid 110, 402 correctly. The sensor system provides a built in test that the anti-ice system 106, 416 is functioning.

In one or more examples, the sensor includes sensing elements 412 distributed on the ice-prone surface 102, 202 such that one or more of the following can be detected and determined: blockage in the flow F of fluid 110, 402 (e.g., blockage in the porous panel 706 from particulates), the flow rate R of the ice protection fluid 110, 402, ice formation 1026, weeping of the ice protection fluid 110, 402, from different sections of a porous panel 706 and onto the ice prone surface 102, 202 (indicating sections of the porous panel in anti ice system 1012, 1010 that are not functioning), unwanted leakage of ice protection fluid 110, 402 from the porous panel 706 in anti ice system 1012, 1010, verification that ice protection fluid 110, 402 is flowing correctly/everywhere needed, functioning of the flow meter 718 indicating the flow of the ice protection fluid 110, 402 in the anti-icing system 1012, 1010. In one instance, signal conditioning of the sensor signal 502 is used to estimate a flow rate R of the ice protection fluid 110, 402.

In one example, the sensor output is used to ensure that various ice prone surfaces 102, 202, are being anti-iced. In another example, the sensor output 502 is used to determine whether water (e.g., rain water) or ice protection fluid 110, 402 is flowing. In yet another example, if the fluid ice protection system 1012, 1010 is activated and the sensor 104, 408, 604 system does not detect ice protection fluid 110, 402 within a specified time, the ice protection system 1012, 1010 activates an alert on the flight deck such as sending the flight crew a warning (e.g., an EICAS message). The flight crew can then attempt a flight level change or change course to find non-icing flight conditions. In yet another example, a maintenance message is sent to request repair of the ice protection system 1012, 1010.

In another example, indication of the presence or absence of ice protection fluid 110, 402 by the sensor 104, 408, 604 is used to adjust the flow F of ice protection fluid 110, 402 provided by the anti-icing system 1012, 1010. For example, the proper amount of ice protection fluid 110, 402 is applied or removed from leading edge 1024, 1028 of the inlet 800 or wings 1010 in response to the sensor indication.

In yet another example, if the sensor 104, 408, 604 indicates leakage around the leading edge 1024, 1028 of the engine inlet 800 or wings 1010, and the flow meter 718 is still pumping fluid 110, 402 but the sensor 104, 408, 604 detects no ice protection fluid 110, 402 is flowing F on the ice prone surfaces 102, 202, then a determination has to be made if the flow meter 718 is not functioning properly or if the porous panel 706 in system 1010, 1012 is blocked. In various examples, the sensor 104, 408, 604 could set a maintenance flag indicating to the maintenance crew where/what needs to be checked.

In an example where unwanted leakage is detected, the ice protection fluid 110, 402 is suctioned out of the porous panel 706 in anti-ice system 1010, 1012 (e.g., using the eductor 712).

In yet another example, the use of the sensor 104, 408, 604 system reduces engine 708 power extraction by more than 98% and reduces airplane weight for the anti-ice system 1010, 1012 by more than 80%.

In a further example, visual inspection to verify the presence of ice protection fluid 110, 402 is unnecessary and is not performed.

In yet a further example, the anti-icing system 1010, 1012 and sensor 104, 408, 604 system are operated anytime the engine 708 is running and fluid 110, 402 flows into the engine. However, the sensor 104, 408, 604 system can be operated when aircraft 1000 is in motion (e.g., fluid 110, 402 into and over the engine 708) or when the aircraft 1000 is stationary.

### FIPS System Embodiments

FIGs. 7A-7J and 8-10 illustrate system 730 embodiments for removing and preventing ice buildup 732, 1806 on an aerodynamic surface 734, 1806a and/or controlling flow F of anti-ice fluid 704 into and out from a porous panel 706. The system 730 comprises a tank 702 connected to the porous panel 706 so as to deliver the anti ice fluid 704 to, and/or remove the anti-fluid 704 from, the porous panel 706 with improved reliability and increased precision not achievable with conventional methods. For example, the FIPS system is capable of delivering/removing the anti-ice fluid 704 with a precision that responds in real time to changes in ice accumulation 1312 detected by an ice detector 1800, 1900.

### FIPS impact on weight and power extraction, according to one or more examples

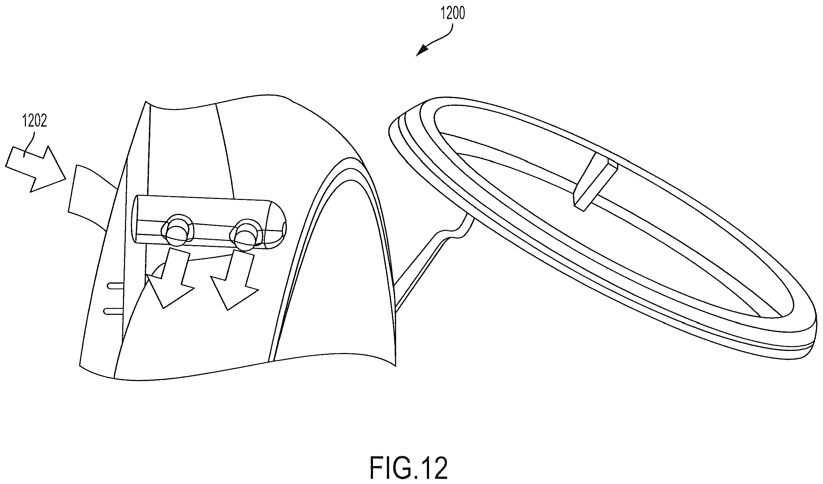

In various examples, the FIPS offers a promising low-temperature, low-pressure anti-ice alternative which avoids the weight, complexity and power demands of a thermally-based system reliant on pneumatic or electrical heat transmission. Such a system decouples EAI from engine power extraction through either bleed or horse-power, and enables a decrease in core size for a UHB engine. In various examples, the FIPS has power requirements reduced by orders of magnitude as compared to an anti-ice pneumatic swirl system as illustrated in FIG. 12.

In the bleed air system of FIG. 12, ice protection is provided by a pneumatic swirl system utilizing hot bleed air from the engine core. A small percentage of the core mass flow is extracted between compressor stages, and transferred to a 'D-duct' formed by the inner surface of the nacelle lip and the upstream surface of the forward bulk-head. Such systems provide ice protection via thermal flux through the nacelle lipskin and are about 50% efficient, with roughly half of the energy in the high pressure, high temperature bleed air transferred through the metallic lip and about half remaining in the overboard exhaust.

In various examples, the FIPS system may enable ultra high bypass ratio engines having reduced engine core size and less thrust required when the FIPS is operating during descent over a pneumatic system.

The descriptions of the various aspects have been presented for purposes of illustration, but are not intended to be exhaustive or limited to the aspects disclosed. Many modifications and variations will be apparent to those of ordinary skill in the art without departing from the scope of the claims. The terminology used herein was chosen to best explain the principles of the aspects, the practical application or technical improvement over technologies found in the marketplace, or to enable others of ordinary skill in the art to understand the aspects disclosed herein.

### ICE DETECTION EMBODIMENTS

The present disclosure describes an aircraft comprising one or more LIDAR detectors having actual ice accretion detection capability when icing is encountered. Current TAT-style moisture sensor in-flight wing ice detectors, on the other hand, can only infer that icing conditions exist around the aircraft because they are unable to detect if ice has actually formed on a surface. After exiting icing conditions, the LIDAR detectors are also capable of detecting natural ice shedding and/or sublimation. This confirmation of the absence of ice allows the stall protection to be reset to normal levels. Conventional surface mounted icing condition detectors, on the other hand, cannot determine when ice has been sublimated or shed (an impracticably/impossibly large number of TAT detectors would have to be used for detecting ice accretion and sublimation).

### LIDAR Apparatus

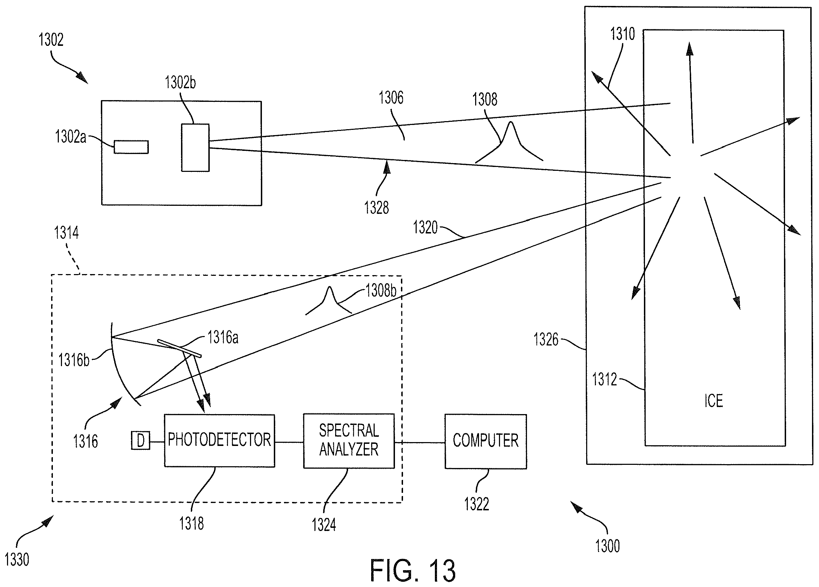

FIG. 13 illustrates the operating principle of a LIDAR sensor 1300 detecting ice 1312 on an aerodynamic surface 1326 of an aircraft 204, according to an embodiment of the present invention. The LIDAR sensor comprises a transmitter 1302 comprising a laser 1302a (e.g., having an eyesafe 1.5 micron wavelength and 1 Watt output power) and emission optics 1302b that transmit a stream or beam 1306 of laser light pulses 1308 to the aerodynamic surface 1326. The light pulses 1306 are reflected or scattered 1310 by ice 1312 on the aerodynamic surface. The LIDAR sensor 1300 further comprises a receiver 1314 comprising reception optics 1316 (including mirrors 1316a and 1316b) and photodetector 1318, wherein the reception optics 1316 is positioned to receive the light pulses 1320 reflected 1310 or scattered by the ice 1312 on the aerodynamic surface and focus the reflected light 1320 onto the photodetector 1318.

In one embodiment, the emission optics 1302b comprises a scanning mechanism or means for steering the laser beam 1306 onto the aerodynamic surface. In one example, scanning mechanism comprises a prism, to achieve a spherical scan pattern of the beam 1306 on the aerodynamic surface. In another embodiment, the emission optics 1302b comprises a mirror mounted on a mount, achieving a rectangular scan pattern of the beam 1306 on the aerodynamic surface. In yet another embodiment, the scanning mechanisms comprises a non-mechanical laser beam steering and zooming mechanism.

FIG. 13 further illustrates the LIDAR sensor 1300 comprises, or is connected to, a processor 1322 performing numerical analysis. The processor 1322 times the reflected signals/light pulses 1320 and/or outputs three dimensional (3D) point cloud data used to measure the aerodynamic surface's coordinates.

Thus, in one or more examples, a detector 1330 comprises one or more of the LIDAR devices 1300 positioned on an aircraft 204, each of the LIDAR devices 1300 including a transmitter 1302 and a receiver 1314, wherein each of the transmitters 1302 repetitively scan 1328 the aerodynamic surface 1326 (e.g., wing 102, empennage 1824, or rotor 1002) on the aircraft 204, using laser pulses 1308, forming scattered laser pulses 1320 scattered from the aerodynamic surface 1326. Each of the receivers 1314 receive the scattered laser pulses 1320 and output data comprising timing of the scattered laser pulses 1320 received in the receiver 1314. Temporal changes in coordinates of the aerodynamic surface 1326, indicating a presence or absence of ice 1312 on the aerodynamic surface 1326, are calculated from the output data. In various examples, the computer 1322 calculates temporal changes in a thickness of the wing 1808, the empennage 1824, or the rotor 1002 from the temporal changes in the coordinates. The computer uses the temporal changes in the thickness (T, see FIG. 9D) to determine accumulation of the ice 1312 or shedding of the ice 1312.

### Ice Detection Processing

In one or more embodiments, the processing takes into account flexibility of the aerodynamic surface (e.g., commercial airplane wings are very flexible and the wing on the Boeing 787 is likely one of the most flexible). The flexing of the wing changes from the 1G load on the ground without fuel to the 1G load on the ground with fuel, to the 1G air loaded wing with greatly varying weight and speed and flap configuration.

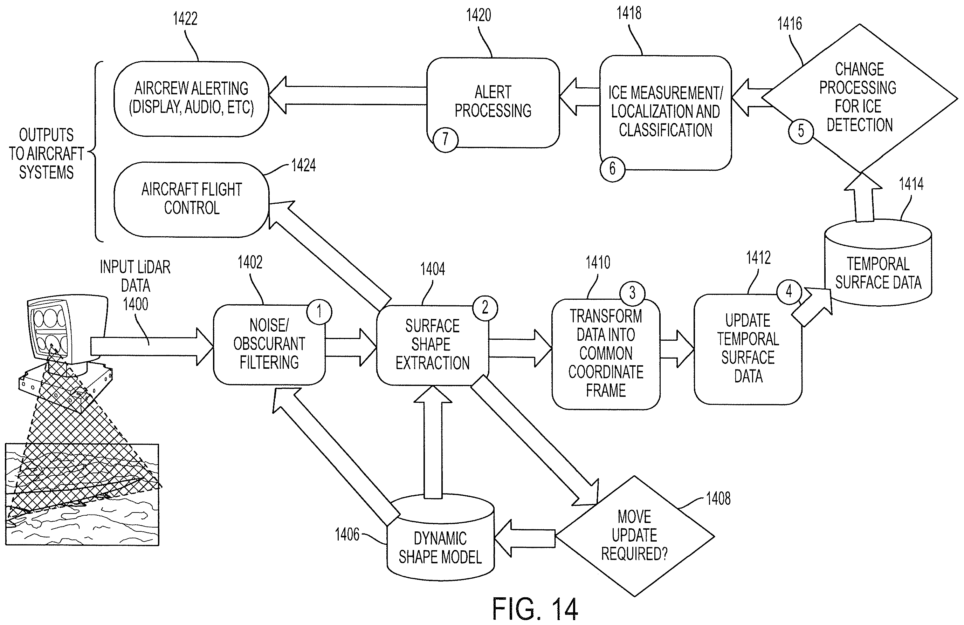

FIG. 14 is a flowchart illustrating a method of processing LIDAR data (e.g., as obtained using the apparatus of FIG. 13) to measure ice on a flexible aerodynamic surface (e.g., of a wing).

Block 1400 represents inputting, to the processor 1322, the 3D point cloud data representing the aerodynamic surface and generated by the LIDAR apparatus mounted on the aircraft. The 3D point cloud data should have sufficient range accuracy, time alignment, and registration to measure ice accumulation. In one embodiment, each data point includes additional data. Examples of additional data include, but are not limited to, polarization or intensity of the LIDAR return beam.

Block 1402 represents pre-processing comprising filtering/removing bad returns due to obscurants (or other particles between the sensor and the aerodynamic surface) from the raw 3D point cloud data. Filtering examples include, but are not limited to, temporal/spatial filtering and waveform return filtering. In temporal/spatial filtering, a priori knowledge of where the aerodynamic surface should be (obtained from previous scans) is used to remove any outlying LIDAR return data that could not possibly originate from the aerodynamic surface. In waveform return filtering, filtering techniques at the individual LIDAR return level are used to determine which returns originate from a scattered/obscurant and which returns are "real" return originating from the aerodynamic surface. In one embodiment, the pulse shape of the return LIDAR beam is analyzed to identify the bad returns [1]. In another embodiment, faint intensity returns are associated with obscurants, whereas higher intensity returns are associated with ice.

Block 1404 represents input pre-processing to extract the shape of the aerodynamic surface. Each time a full 3D point cloud is formed from the LIDAR data scan of the aerodynamic surface, the pre-processing simplifies these collected points into a shape model 1406 for the aerodynamic surface. Examples of methods that are used include, but are not limited to, simple edge extraction and more complex model based methods [2] that extract the aerodynamic surface shape from the 3D point cloud data. Thus, the pre-processing can determine one or more deformations in the shape due to flexing of the aerodynamic surface.

Block 1408 represents providing updates to the model to define current surface shape and reference data into a common coordinate frame.

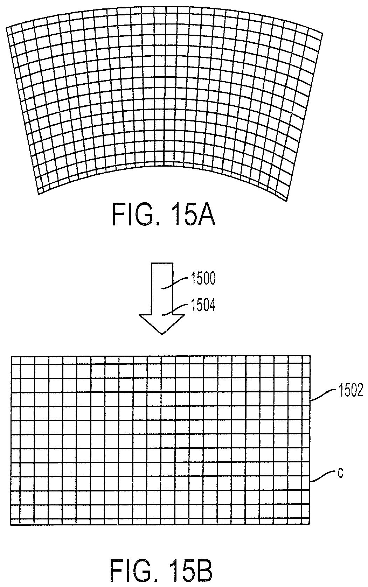

Block 1410 represents transformation of the current data into common surface data construct/frame using a transformation function. Once the shape has been extracted it is necessary to transform the data into a reference to that it can be compared over time periods where the shape is constantly changing (e.g., due to the vibrations or flexing). In one embodiment, the transformation uses witness points that are clearly identifiable (e.g. wing tips or control surfaces) to refine the shape distortion measurement. FIG. 15A illustrates a reference frame showing the deformed shape due to flexing, FIG. 15B illustrates a common reference frame comprising the aerodynamic surface without the deformations due to flexing, and the arrow 1500 illustrates the transformation function that transforms the aerodynamic surface having the deformations into the aerodynamic surface without the deformations.

In one embodiment, as the leading edge changes configurations and slats are deployed, the LIDAR system checks the coordinates against a set of slat datasets.

Block 1412 represents providing updates to a temporal database 1414 of surface measurements. Once the filtered 3D point cloud data has been transformed into new coordinates in a common frame, the new coordinates are stored in the temporal database. While processing in previous steps comprised processing the shape of the aerodynamic surface, the processing in this step analyzes a more robust set of data that includes return intensity, polarization, etc. The end result is a set of data from which the last N number (corresponding to N different time measurements) of collocated surface points are compared. Consequently, the accumulation or the shedding of ice on the aerodynamic surface can be detected by analyzing the temporal changes in the coordinates in the common reference frame.

Block 1416 represents changing detection to cue ice accumulation or shedding. This process looks at the current and N previous data from the aerodynamic surface to detect ice. Examples of the detection process include detecting buildup or deformation, a shift in the intensity returned from a portion of the wing, or a shift in the polarization indicating a different type of material. Examples of methods that are used range from, but are not limited to, a simple threshold change detection to a full blown machine learning construct that is trained on sample data.

In one embodiment, the LIDAR comprises a spectrum analyzer 1324 and the guided pulses 208 are sampled over a range of frequencies to the spectral analyzer in order to yield a rich source of data on surface contaminants. In one embodiment, the surface is checked real time against a curvature or other database (e.g., standard spectral reflectivity or bidirectional reflectance distribution function table) and a contaminant map is created. By understanding the different surface coordinate changes of the aerodynamic surface, the system is made either sensitive or insensitive to certain contaminant types. As an example, certain coordinate change patterns are related to ice but not water.

Alternatively, the LIDAR ice detector can also serve as a detector which can differentiate between regular icing and SLD icing conditions (based on location and character of the ice).

Block 1418 represents ice measurement, localization and classification. This is a process to measure the thickness, localize/segment the area, and classify the type of ice formed. Possible methods utilized include classification (e.g., neural nets, support vector machines (SVMs), k-nearest neighbor algorithms (KNN), and Bayesian methods) and localization (growing nearest neighbor search, multi-resolution subsampling).

Block 1420 represents alert processing / generation. In one embodiment, once the ice is localized, classified, and the thickness is measured, higher level knowledge of icing on the aerodynamic surface is used to decide if and how to alert the crew 1422 or other aircraft system 1424 (e.g., ice on certain areas might be less critical, certain types of ice might be a greater concern, etc.). In one embodiment, the data forms a real time graphic for pilots on the ground, in visual conditions and in low visibility conditions.

Currently flight control systems do not adjust for in-flight wing flexing directly. The flight controls react in response to aircraft level detection systems and must use additional force to compensate for the inertia that is built up in the portions of a second that today's systems can react in. In one embodiment, wing location data received from the LIDAR system is communicated directly to flight control systems to allow the aircraft to react more quickly to in flight conditions.

### Ice Detector Positioning Embodiments

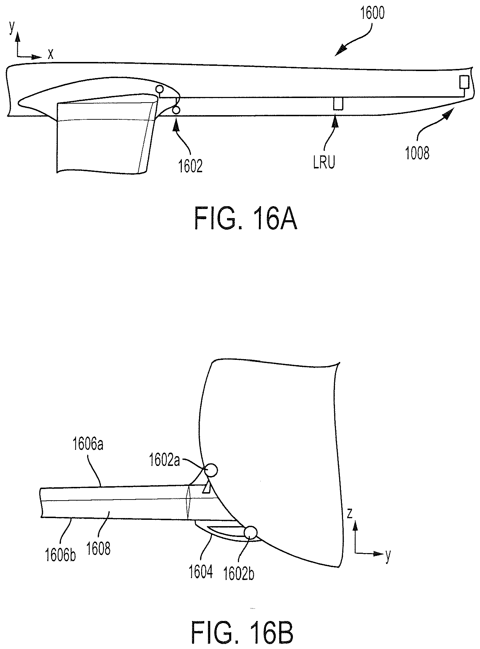

FIG. 16A and 16B illustrate an ice detector embodiment for use on an aircraft 1600, comprising a plurality of LIDAR devices 1602a, 1602b each including a transmitter 220 and a receiver 222, wherein the LIDAR devices are disposed in an aircraft fairing 1604. In each LIDAR device 200, the transmitter 220 transmits laser pulses 208 to the aerodynamic surface(s) 1606a, 1606b on the aircraft's wing 1608 and the receiver 222 receives the laser pulses 1308 reflected/scattered off of the wing 1608. One of the LIDAR devices 1602a transmits/receives laser pulses 208, 220 to/from the upper surface 1606a of the wing 1608 and one of the LIDAR devices 1602b transmits/receives laser pulses 208, 220 to/from the lower surface 1606b of the wing 1608.

In one embodiment, the transmitters 222 comprise laser 1302a and emission optics 1302b and the receivers 222 comprise reception optics 1316 and photodetector 1318 as illustrated in FIG. 13. and the aerodynamic surface's coordinates are determined based on timing of the laser pulses reflected off the aerodynamic surface (e.g., using the processing illustrated in FIG. 14).

FIG. 16A shows the icing data is fed into a LRU to be compared against a database, wherein the database informs the aircraft in-flight computers with icing levels. In one embodiment, the LIDAR implementation reduces wiring, bonding requirements, and the number of sensors needed per wing, as compared to conventional probe (TAT) based detectors.

LIDAR devices are not limited to positioning behind an aircraft fairing, as illustrated in FIGs. 16A, 16B, and 6. Further examples of LIDAR positioning include, but are not limited to, inside the aircraft fuselage or in a bubble on the aircraft fuselage (e.g., near the nose of the aircraft). Such examples enable flight hardened all weather ice detection and increased reliability, and assured operations in austere environments such as the arctic.

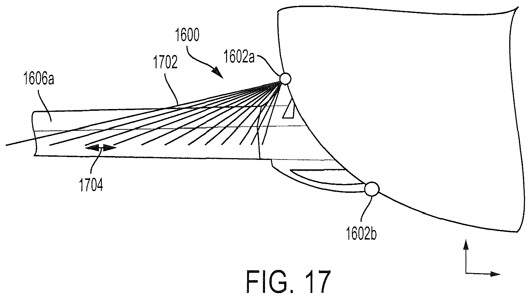

FIG. 17 illustrates an embodiment wherein the transmitter 220 scans the aerodynamic surface 1606a of the wing 1608 in one or more line patterns 1700 across cross-sections 1702 of the wing 1608 so that the light pulses 1308 swept/scanned in the line patterns 1700 measure the cross-sections 1702 of the aerodynamic surface 1606a, 1606b of the wing 1608. The scan speed determines the distance 1704 between the cross-sections 1702, and the distance determines the line-density of the cross-sections 1702 on the aerodynamic surface 1606a. Thus, the computer 1322 uses one or more of the scanning speeds of the scan 1328 to measure distances 1704 between the cross-sections 1702. In one embodiment, changes in the line density are used to measure flexing of the wing. By monitoring the coordinate change of the aerodynamic surface 1606a over time, the scanning adapts to the wing flex and still builds an accurate image of aerodynamic surface 1606a.

FIGs. 16-17 further illustrate the positioning of multiple LIDAR devices 200. In one example, a first LIDAR device 1602a is positioned to scan 1328 the aerodynamic surface 1324 comprising an upper surface 1606a of the wing 1608 by transmitting the laser pulses 1308 to the upper surface 1606a, wherein the timing outputted from the first LIDAR device 1602a is used to determine the coordinates of the upper surface 1606a; and a second LIDAR device 1602b is positioned to scan the aerodynamic surface 1324 comprising a lower surface 1606b of the wing 1608 by transmitting the laser pulses 1308 to the lower surface 1606b, wherein the timing outputted from the second LIDAR device 1602b is used to determine the coordinates of the lower surface 1606b. In another example, a first LIDAR device 1300 is positioned to transmit the laser pulses 1308 to the upper surface 1606a of the wing 1608, wherein the timing outputted from the first LIDAR device 1300 is used to determine the coordinates of the upper surface 1606a in a first direction x; a second LIDAR device 1300 is positioned to transmit the laser pulses 208 to the upper surface 1606a of the wing, wherein the timing outputted from the second LIDAR device 200 is used to determine the coordinates of the upper surface 1606a in a second direction y; a third LIDAR device 1300 is positioned to transmit the laser pulses 1308 to the lower surface 1606b of the wing 1608, wherein the timing outputted from the third LIDAR device 1300 is used to determine the coordinates of the lower surface 1606b in the first direction x; and a fourth LIDAR device 1300 is positioned to transmit the laser pulses 208 to the lower surface 1606b of the wing 1608, wherein the timing outputted from the fourth LIDAR device 200 is used to determine the coordinates of the lower surface 1606b in the second direction y.

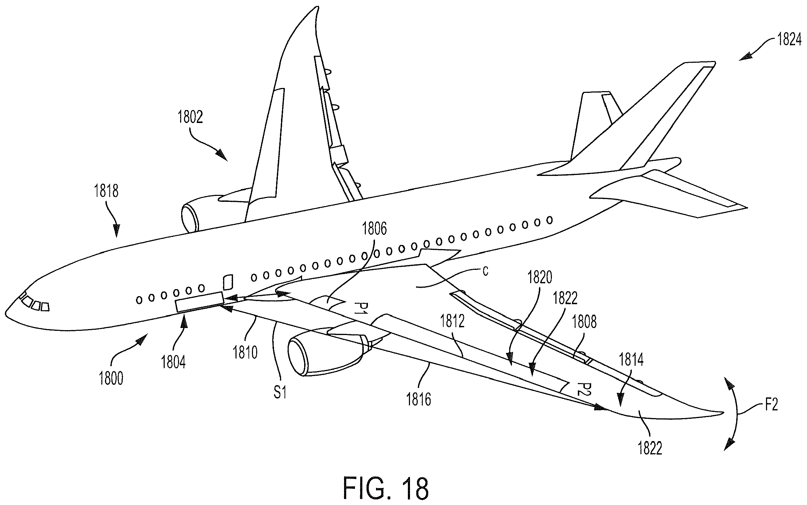

FIG. 18 illustrates an installation of an ice detector 1800 on an aircraft 1802, wherein the ice detector 1800 includes a LIDAR system 1804 measuring ice formation 1806 on the aircraft's wing 1808. The LIDAR system 1804 emits a LIDAR beam 1810 (e.g., a laser beam) sweeping S1 the wing leading edge 1812 to determine the shape 1814 of the wing leading edge 1812, thereby determining if any ice is accumulating on the wing leading edge 1812. The LIDAR system includes a transmitter transmitting the LIDAR beam 1810 to the wing leading edge 1812 and a receiver detecting the LIDAR beam's reflection (return beam) 1816 from the wing leading edge 1812.

In various examples, the LIDAR system 1804 is positioned in the aircraft's fuselage 1818 forward of the wing 1808. In various examples, positioning of the LIDAR system 1804 closer to the wing 1808 allows an actuator in the LIDAR device 1804 to sweep S the LIDAR beam 1810 over a larger angle.

Also shown a porous panel 1820 for distributing ice protection fluid in an anti-ice system 1822. In various examples, the LIDAR system 1804 monitors the functioning of the anti-ice system 1822.

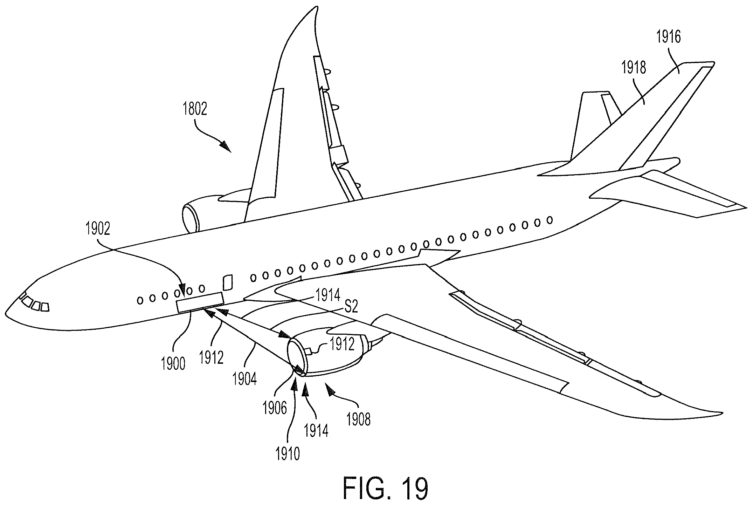

FIG. 19 illustrates installation of an ice detector 1900 comprising a LIDAR system 1902 emitting a LIDAR beam 1904 sweeping S2 the engine inlet 1906 (of the nacelle 1908) to determine the shape 1910 of the engine inlet 1906 and if any ice 1912 is accumulating on the engine inlet 1906. The LIDAR system 1902 includes a transmitter transmitting the LIDAR beam 1904 to the engine inlet 1906 and a receiver detecting the LIDAR beam's reflection 1914 from the engine inlet 1906.

More generally, the LIDAR system is mounted on the aircraft 1802 so as to measure the shape of a range of aerodynamic surfaces 1916 on the aircraft 1802 in a sweeping manner, thereby detecting ice formation 1912,1806 on the aerodynamic surface 1916. Examples of aerodynamic surfaces 1916 include, but are not limited to, aerodynamic surfaces on a tail 1918, a wing 1808, and/or an engine inlet 1906.

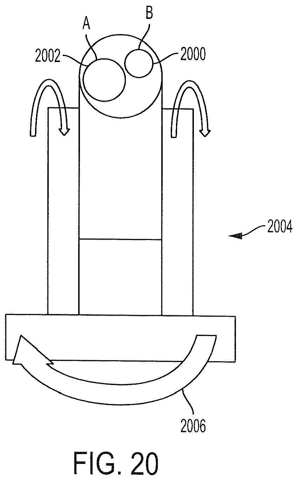

FIG. 20 illustrates the LIDAR system 1902 includes a transmitter 2000 and receiver 2002 mounted on actuators (a two axis mount 2004) that rotate 2006, 2008 around two axes to sweep the LIDAR beam 1810, 1904 over the aerodynamic surface 1916, thereby detecting the ice 106,1912. Using the actuators 1904 to move or sweep the LIDAR beam 1810, 1904 across the aerodynamic surfaces 1916 gives a more complete analysis of ice accumulations 1806, 1912 on the aerodynamic surfaces than an ice detector positioned on the aerodynamic surfaces. The transmitter 2000 and receiver 2002 are positioned at two different locations A, B on the mount 2004 on the aircraft 1802.

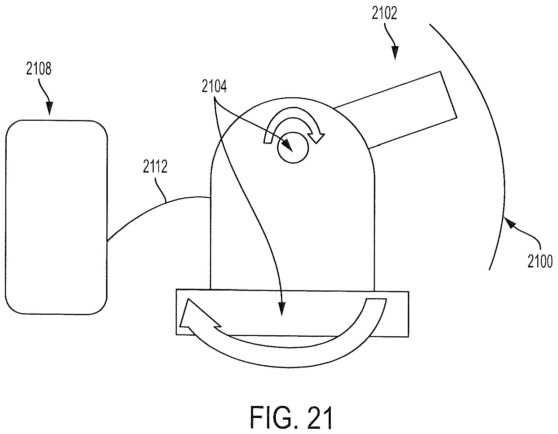

FIG. 21 illustrates installation of the LIDAR system 1902, 1804 inside the aircraft's fuselage 1818 and behind an optical window 2100. The LIDAR transmitter 2000 and receiver 2002 are mounted in a LIDAR transmitter and receiver housing 2102. The housing 2102 is mounted on a two axis mount 2004 rotating the housing 2102 around two axes 2104 of rotation.

In various examples, the window 2100 is flush with the aircraft fuselage 1818. The transmitter 2000 transmits the LIDAR beam 1810, 1904 through the window 2100, and the receiver 2002 detects the reflected LIDAR beam 1914 through the window 2100 after the LIDAR beam 1904 has reflected off the aerodynamic surface 1916 outside the fuselage 1818.

FIG. 21 further illustrates the LIDAR system 1804, 1902 includes a computational unit 2108 (including processors) connected 2110 to the transmitter 2000 and receiver 2002. The computer unit 2108 performs the required computations to measure the time of flight of the LIDAR beam 1810, 1904 between the transmitter 2000 and the receiver 2002. The computational unit 2108 further uses the time of flight to determine ice accumulation 1806, 1912 on the aerodynamic surface 1916. The one or more processors in the computation unit 2108 determine and output ranging data including the travel times of the LIDAR beam 1810, 1904 from the transmitter 2000 to the receiver 2002 via one or more different locations PI, P2 swept S1, S2 on the aerodynamic surface 1916. Distances from the LIDAR system 1804, 1902 to the one or more locations PI, P2 on the aerodynamic surface 1916 are calculated from the travel times. The distances and/or travel times change as ice 1806, 1912 accumulates on, or is eliminated from, the aerodynamic surfaces 1916.

In various examples, the distances and/or travel times are used to determine a shape 1814, 1910 of the aerodynamic surface 1916. The change in shape 1814, 1910 of the aerodynamic surface 1916 is determined by measuring the variations or differences in distances and/or travel time in real time, continuously, between different times, and/or at different time intervals. Thus, in one example, sweeping the LIDAR beam 1810, 1904 across the aerodynamic surface 1916 measures the shape 1814, 1910 of the aerodynamic surface 1916 in real time. The variations in time of flight are associated with a change in shape 1814, 1910 of the aerodynamic surface 1916 and/or with accumulation, formation, or elimination of ice 1806, 1912 on the aerodynamic surface 1916.

In various examples, the measured shape 1814, 1910 of the aerodynamic surface 1916 is compared with (e.g., subtracted from) tabulated data representing the aerodynamic surface 1916 deformation under different conditions. In various examples, the tabulated data is found in look up tables. The different conditions include, but are not limited to, iced aerodynamic surface, anti-iced aerodynamic surface, aerodynamic shape for different aircraft speeds, and aerodynamic surface at different temperatures. The difference between the tabulated data and the LIDAR measured shape then indicates the presence or absence of ice on the aerodynamic surface.

In another example, the unit 2108 includes (or is) a laser source providing the light source for the LIDAR beam and connection 2112 is an optical fiber.

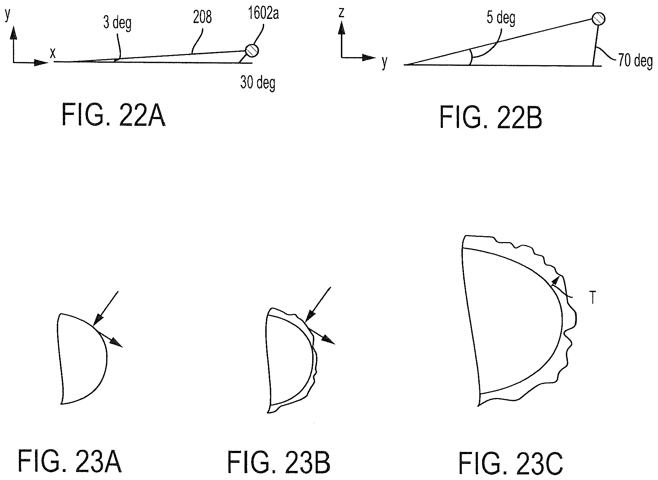

FIG. 22 illustrates embodiments wherein each of the LIDAR units 1602a transmits the laser pulses 1308 making a 3-30 degree angle of incidence on the wing in relation to the y axis in the x-y plane and a 5-70 degree angle of incidence on the wing in reference to the y axis in the z-y plane. In one embodiment, the LIDAR devices comprise gimballed stereo wide angle LIDAR units in order to achieve a range of angles of incidence. This allows in-flight data to be collected within 100 meters and 30-80 degree incidence angles.

FIG. 23A-23C are illustrations showing measurement of ice shapes and thickness T.

Other aspects may also be used to prevent ice accumulation on other craft, including, but not limited to, military aircraft, rotorcraft, and UAVs, or on cold, condensing surfaces where atmospheric air cause ice formation, such as on terrestrial auxiliary heat exchangers used in nitrogen recovery systems and cryogenic fuel tanks such as those used on launch vehicles.

### Ice detection System Embodiments

FIGs. 13-23C illustrate an ice detector 1800, 1900 for use of an aircraft 204, comprising a LIDAR device 1300, 1804, 1902 comprising a transmitter 1302, 2000 and a receiver 1314, 2002 placed at one or more locations on the aircraft 204 for measuring ice 1806, 1912 on one or more aerodynamic surfaces 1916 of the aircraft 204. Examples of the aerodynamic surface 1916 include, but are not limited to, the surface of a wing 1808, a tail or empennage 1918, a rotor 900, or an engine inlet 1906. Conventional detectors are not capable of measuring ice accumulation and ice sublimation in real time, as provided by embodiments of the ice detectors 1800, 1900 described herein.

### Processing Environment

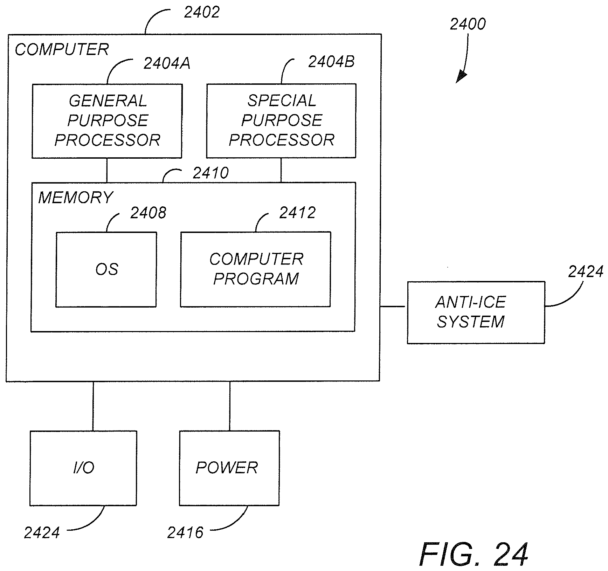

FIG. 24 illustrates an exemplary system 2400 comprising a computer 2402 that could be used to implement processing elements described herein, such as processing the data from the sensor 104, 206, 304, 502 (e.g., indicating the presence of ice protection fluid 110, 402, 610 from the LIDAR 108, metal detector 408, or conductivity sensor 604 output), processing the data D from the ice detectors 1800, 1900 so as to measure the presence/absence of ice 1312, activate/deactivate the anti-ice system 106. The computer 2400 may also be used as a flight deck indication system. The computer 2402 is typically located on the aircraft.

The computer 2402 comprises a processor (comprising general purpose processor 2404A and special purpose processor 2404B) and a memory, such as random access memory (RAM) 2406. Generally, the computer 2402 operates under control of an operating system 2408 stored in the memory 2406, and interfaces with the user to accept inputs and commands (analog or digital signals) and to present results through an input/output module 2410. The computer program application 2412 accesses and manipulates data stored in the memory 2406 of the computer 2402. The operating system 2408 and the computer program 2412 are comprised of instructions which, when read and executed by the computer 2402, cause the computer 2402 to perform the operations herein described. In one embodiment, instructions implementing the operating system 2408 and the computer program 2410 are tangibly embodied in the memory 2406, thereby making a computer program product or article of manufacture. As such, the terms "article of manufacture," "program storage device" and "computer program product" as used herein are intended to encompass a computer program accessible from any computer readable device or media.

In one embodiment, computer 2402 comprises one or more field programmable gate arrays (FPGAs).

In one embodiment, the computer 2402 receives a signal through I/O 2410 from the sensor/detector. In response, the computer 2402 calculates the presence of ice protection fluid 704 and/or ice 1312 on the aerodynamic surface, activates/deactivates the anti ice system 106, and/or alerts the flight crew when the ice detector detects ice. The flight crew may turn on or deactivate the anti-ice system 106 and/or move the airplane out of the icing condition in response to the flight deck indication.

FIG. 24 further illustrates a power source 2416 for providing power to the system 2400.

Those skilled in the art will recognize many modifications may be made to this configuration without departing from the scope of the present disclosure. For example, those skilled in the art will recognize that any combination of the above components, or any number of different components, peripherals, and other devices, may be used.

While the foregoing is directed to aspects of the present invention, other and further aspects of the invention may be devised without departing from the basic scope thereof, and the scope thereof is determined by the claims that follow.

## Claims

1. A system (100) for anti-icing an ice-prone surface (102) of a subsonic aircraft (204), comprising:
a sensor (104) to indicate presence of ice protection fluid (110) on an ice prone surface (102) of an aircraft (204), wherein the sensor comprises a Light Detection and Ranging (LIDAR) system (108) emitting a LIDAR beam (128); and
an anti-icing system (106) on the ice-prone surface (102) regulating flow rate of the ice protection fluid (110) on the ice prone surface (102) based on input from the sensor (104) regarding the presence of the ice-protection fluid (110).

2. The system (100) of claim 1, wherein:
the ice protection fluid (110) comprises suspended particulates (126) that reflect a specific wavelength of the LIDAR beam (128) back to the LIDAR system (108), and
detection of the specific wavelength by a receiver in the LIDAR system indicates the presence of ice protection fluid.

3. The system (100) of claim 1, wherein:
the LIDAR system (108) comprises one or more transmitters (116) transmitting the LIDAR beam and one or more receivers (118) receiving the LIDAR beam, and
the transmitters and the receivers are flush mounted along the ice-prone surface.

4. The system (100) of claim 1, wherein the LIDAR system (108) is mounted in the aircraft's fuselage (210) and the LIDAR system emits the LIDAR beam (128) sweeping the ice-prone surface to measure the presence of the ice protection fluid, and the LIDAR system measures a presence of particles (126) in the ice protection fluid from LIDAR backscatter in order to detect the ice protection fluid.

5. The system (100) of claim 1, further comprising metal particles (400) added to the ice protection fluid (110), wherein the sensor is a metal detector (410) sensing flow of the metal particles in the ice-protection fluid.

6. The system (100) of claim 5, wherein:
the metal particles (400) comprise iron in a ferrofluid added to the ice protection fluid, and
the metal detector (410) comprises a magnetic field sensor sensing a change in a magnetic field due to the metal particles.

7. The system (100) of claim 5, wherein:
the metal detector (410) comprises sensing elements (412) integrated on a porous panel (706) on the ice-prone surface (102),
the porous panel (706) comprises a weeping portion from which the ice-protection fluid weeps onto the ice-prone surface to remove or prevent ice build-up on the ice-prone surface, and
the sensing elements (412) are positioned downstream from the weeping portion.

8. The system (100) of claim 5, wherein:
the metal particles (400) comprise iron in a ferrofluid added to the ice protection fluid, and
the sensing elements (412) comprise wire loops printed onto an inside of the porous panel (706),
the porous panel (706) distributing ice-protection fluid onto the ice-prone surface to remove or prevent ice build-up on the ice-prone surface, and
the wire loops sensing a change in magnetic field due to flow of the iron in the ice protection fluid.

9. The system (100) of claim 5, wherein the metal particles (400) are nanoparticles distributed homogenously in the ice-protection fluid (110).

10. The system (100) of claim 1, wherein the sensor (104) comprises:
electrical contact pairs (608) having their circuit closed when the ice protection fluid makes an electrical pathway between them.

11. The system (100) of claim 10, wherein the electrical contact pairs (608) measure impedance and/or voltage between two contact points (612) on the ice-prone surface to differentiate the ice protection fluid from water flowing on the ice-prone surface.

12. The system of claim 11, wherein the ice protection fluid (110) comprises metal particles (400) that increase conductivity of the ice-protection fluid.

13. The system (100) of claim 1, further comprising an alert system activated when the anti-icing system is activated and the sensor does not detect the ice-protection fluid to a target level within a specified period of time, so that a non-icing flight condition can be found.

14. The system (100) of claim 1, wherein:
the anti-icing system (106) comprises a flow meter (718) indicating the flow of the ice protection fluid, and
the sensor comprises sensing elements (412) distributed on the ice-prone surface such that one or more of the following can be detected:
blockage in the flow and the flow rate of the ice protection fluid,
weeping of the ice protection fluid from different sections of a porous panel (706) and onto the ice prone surface,
unwanted leakage of ice protection fluid from the porous panel (706), and
functioning of the flow meter.

15. The system (100) of claim 14, further comprising an eductor (712) evacuating ice protection fluid from the porous panel using engine bleed air when the unwanted leakage is detected.

16. The system (100) of claim 1, wherein the ice prone surface is a leading edge (112) of a wing (308), a tail (224), or an engine inlet (214) on the aircraft.

17. The system (100) of claim 1, wherein the sensor comprises RADAR, Microwave, or Millimeter Wave signals.

18. A method of anti-icing an ice prone surface (102) of an aircraft (204), comprising:
sensing a presence of ice protection fluid (110) on an ice-prone surface (102) of an aircraft, wherein the sensing uses Light Detection and Ranging; and
verifying functioning of a anti-icing system on the ice-prone surface based on input from the sensing.

19. The method of claim 18, wherein the sensing detects a conductivity and/or a magnetic property of the ice protection fluid to indicate the presence of the ice protection fluid.

## Patentansprüche

1. System (100) zur Enteisung einer vereisungsgefährdeten Oberfläche (102) eines Unterschallflugzeugs (204), das aufweist:
einen Sensor (104), um das Vorhandensein des Eisschutzfluids (110) auf einer vereisungsgefährdeten Oberfläche (102) eines Flugzeugs (204) anzuzeigen, wobei der Sensor ein LIDAR-System (Light Detection and Ranging system) (108), das einen LIDAR-Strahl (128) emittiert, aufweist; und
ein Enteisungssystem (106) auf der vereisungsgefährdeten Oberfläche (102), das die Durchflussmenge des Eisschutzfluids (110) auf der vereisungsgefährdeten Oberfläche (102) basierend auf einer Eingabe von dem Sensor (104) bezüglich des Vorhandenseins des Eisschutzfluids (110) reguliert.

2. System (100) nach Anspruch 1, wobei:
das Eisschutzfluid (110) Schwebeteilchen (126) aufweist, die eine spezifische Wellenlänge des LIDAR-Strahls (128) zu dem LIDAR-System (108) zurück reflektieren, und
die Erfassung der spezifischen Wellenlänge durch einen Empfänger in dem LIDAR-System das Vorhandensein des Eisschutzfluids anzeigt.

3. System (100) nach Anspruch 1, wobei:
das LIDAR-System (108) einen oder mehrere Sender (116), die den LIDAR-Strahl übertragen, und einen oder mehrere Empfänger (118), die den LIDAR-Strahl empfangen, aufweist, und
die Sender und die Empfänger entlang der vereisungsgefährdeten Oberfläche bündig montiert sind.

4. System (100) nach Anspruch 1, wobei das LIDAR-System (108) im Rumpf (210) des Flugzeugs montiert ist und das LIDAR-System den LIDAR-Strahl (128) emittiert, der die vereisungsgefährdete Oberfläche abtastet, um das Vorhandensein des Eisschutzfluids zu messen, und das LIDAR-System ein Vorhandensein von Teilchen (126) in dem Eisschutzfluid aus der LIDAR-Rückstreuung misst, um das Eisschutzfluid zu erfassen.

5. System (100) nach Anspruch 1, das weiterhin dem Eisschutzfluid (110) zugesetzte Metallteilchen (400) aufweist, wobei der Sensor ein Metalldetektor (410) ist, der einen Strom der Metallteilchen in dem Eisschutzfluid abtastet.

6. System nach Anspruch 5, wobei:
die Metallteilchen (400) Eisen in einem Ferrofluid, das dem Eisschutzfluid zugesetzt ist, aufweisen, und
der Metalldetektor (410) einen Magnetfeldsensor aufweist, der eine Änderung eines Magnetfelds bedingt durch die Metallteilchen abtastet.

7. System (100) nach Anspruch 5, wobei:
der Metalldetektor (410) Abtastelemente (412), die auf einer porösen Platte (706) auf der vereisungsgefährdeten Oberfläche (102) integriert sind, aufweist,
die poröse Platte (706) einen Tröpfelabschnitt, von dem das Eisschutzfluid auf die vereisungsgefährdete Oberfläche tröpfelt, aufweist, um einen Eis-Aufbau auf der vereisungsgefährdeten Oberfläche zu entfernen oder zu verhindern, und
die Abtastelemente (412) stromabwärts von dem Tröpfelabschnitt positioniert sind.

8. System (100) nach Anspruch 5, wobei:
die Metallteilchen (400) Eisen in einem dem Eisschutzfluid zugesetzten Ferro-fluid aufweisen, und
die Abtastelemente (412) auf ein Inneres der porösen Platte (706) gedruckte Drahtschleifen aufweisen,
die poröse Platte (706) Eisschutzfluid auf der vereisungsgefährdeten Oberfläche verteilt, um einen Eis-Aufbau auf der vereisungsgefährdeten Oberfläche zu entfernen oder zu verhindern, und
die Drahtschleifen eine Änderung des Magnetfelds aufgrund des Stroms des Eisens in dem Eisschutzfluid abtasten.

9. System (100) nach Anspruch 5, wobei die Metallteilchen (400) homogen in dem Eisschutzfluid (110) verteilte Nanoteilchen sind.

10. System (100) nach Anspruch 1, wobei der Sensor (104) aufweist:
elektrische Kontaktpaare (608) deren Schaltung geschlossen ist, wenn das Eisschutzfluid eine elektrische Leitung zwischen ihnen herstellt.

11. System (100) nach Anspruch 10, wobei die elektrischen Kontaktpaare (608) die Impedanz und/oder Spannung zwischen zwei Kontaktpunkten (612) auf der vereisungsgefährdeten Oberfläche messen, um das Eisschutzfluid von Wasser, das auf der vereisungsgefährdeten Oberfläche strömt, zu unterscheiden.

12. System nach Anspruch 11, wobei das Eisschutzfluid (110) Metallteilchen (400) aufweist, welche eine Leitfähigkeit des Eisschutzfluids erhöhen.

13. System (100) nach Anspruch 1, das weiterhin ein Warnsystem aufweist, das aktiviert wird, wenn das Enteisungssystem aktiviert ist und der Sensor das Eisschutzfluid innerhalb einer spezifischen Zeitspanne nicht mit einem Zielniveau erfasst, so dass ein eisfreier Flugzustand ermittelt werden kann.

14. System (100) nach Anspruch 1, wobei:
das Enteisungssystem (106) ein Durchflussmessgerät (718) aufweist, das den Strom des Eisschutzfluids anzeigt, und
der Sensor Abtastelemente (412) aufweist, die derart auf der vereisungsgefährdeten Oberfläche verteilt sind, dass ein oder mehrere der folgenden erfasst werden können:
Blockieren der Strömung und der Durchflussmenge des Eisschutzfluids,
Tröpfeln des Eisschutzfluids aus unterschiedlichen Abschnitten einer porösen Platte (706) und auf die vereisungsgefährdete Oberfläche,
unerwünschtes Lecken von Eisschutzfluid von der porösen Platte (706), und
Arbeiten des Durchflussmessgeräts.

15. System (100) nach Anspruch 14, das weiterhin eine Absaugvorrichtung (712) aufweist, die unter Verwendung von Motorzapfluft Eisschutzfluid von der porösen Platte absaugt, wenn das unerwünschte Lecken erfasst wird.

16. System (100) nach Anspruch 1, wobei die vereisungsgefährdete Oberfläche eine führende Kante (112) eines Flügels (308), eines Hecks (224) oder eines Motoreinlasses (214) auf dem Flugzeug ist.

17. System (100) nach Anspruch 1, wobei der Sensor RADAR-, Mikrowellen- oder Millimeterwellensignale aufweist.

18. Verfahren zur Enteisung einer vereisungsgefährdeten Oberfläche (102) eines Flugzeugs (204), das aufweist:
Abtasten eines Vorhandenseins von Eisschutzfluid (110) auf einer vereisungsgefährdeten Oberfläche (102) eines Flugzeugs, wobei das Abtasten LIDAR verwendet; und
Überprüfen der Funktion eines Enteisungssystems auf der vereisungsgefährdeten Oberfläche basierend auf der Eingabe von der Abtastung.

19. Verfahren nach Anspruch 18, wobei das Abtasten eine Leitfähigkeit und/oder eine magnetische Eigenschaft des Eisschutzfluids erfasst, um das Vorhandensein des Eisschutzfluids anzuzeigen.

## Revendications

1. Système (100) pour un dégivrage d'une surface sujette à la formation de glace (102) d'un aéronef (204) subsonique, comprenant :
un capteur (104) pour indiquer une présence d'un fluide de protection contre la glace (110) sur une surface sujette à la formation de glace (102) d'un aéronef (204), dans lequel le capteur comprend un système de détection et télémétrie par la lumière (LIDAR) (108) émettant un faisceau LIDAR (128) ; et
un système de dégivrage (106) sur la surface sujette à la formation de glace (102) régulant un débit du fluide de protection contre la glace (110) sur la surface sujette à la formation de glace (102) sur la base d'une entrée à partir du capteur (104) concernant la présence du fluide de protection contre la glace (110).

2. Système (100) selon la revendication 1, dans lequel :
le fluide de protection contre la glace (110) comprend des particules (126) en suspension qui réfléchissent une longueur d'onde spécifique du faisceau LIDAR (128) en retour vers le système LIDAR (108), et
une détection de la longueur d'onde spécifique par un récepteur dans le système LIDAR indique la présence d'un fluide de protection contre la glace.

3. Système (100) selon la revendication 1, dans lequel :
le système LIDAR (108) comprend un ou plusieurs transmetteurs (116) transmettant le faisceau LIDAR et un ou plusieurs récepteurs (118) recevant le faisceau LIDAR, et
les transmetteurs et les récepteurs sont montés alignés le long de la surface sujette à la formation de glace.

4. Système (100) selon la revendication 1, dans lequel le système LIDAR (108) est monté dans le fuselage (210) de l'aéronef et le système LIDAR émet le faisceau LIDAR (128) balayant la surface sujette à la formation de glace pour mesurer la présence du fluide de protection contre la glace, et le système LIDAR mesure une présence de particules (126) dans le fluide de protection contre la glace à partir d'une rétrodiffusion LIDAR afin de détecter le fluide de protection contre la glace.

5. Système (100) selon la revendication 1, comprenant en outre des particules métalliques (400) ajoutées au fluide de protection contre la glace (110), dans lequel le capteur est un détecteur de métal (410) détectant un écoulement des particules métalliques dans le fluide de protection contre la glace.

6. Système (100) selon la revendication 5, dans lequel :
les particules métalliques (400) comprennent du fer dans un ferrofluide ajouté au fluide de protection contre la glace, et
le détecteur de métal (410) comprend un capteur de champ magnétique détectant un changement dans un champ magnétique en raison des particules métalliques.

7. Système (100) selon la revendication 5, dans lequel :
le détecteur de métal (410) comprend des éléments de détection (412) intégrés sur un panneau poreux (706) sur la surface sujette à la formation de glace (102),
le panneau poreux (706) comprend une portion de suintement à partir de laquelle le fluide de protection contre la glace suinte sur la surface sujette à la formation de glace pour éliminer ou empêcher une accumulation de glace sur la surface sujette à la formation de glace, et
les éléments de détection (412) sont positionnés en aval de la portion de suintement.

8. Système (100) selon la revendication 5, dans lequel :
les particules métalliques (400) comprennent du fer dans un ferrofluide ajouté au fluide de protection contre la glace, et
les éléments de détection (412) comprennent des boucles de fils imprimées sur un intérieur du panneau poreux (706),
le panneau poreux (706) distribuant un fluide de protection contre la glace sur la surface sujette à la formation de glace pour éliminer ou empêcher une accumulation de glace sur la surface sujette à la formation de glace, et
les boucles de fils détectant un changement dans un champ magnétique en raison d'un écoulement du fer dans le fluide de protection contre la glace.

9. Système (100) selon la revendication 5, dans lequel les particules métalliques (400) sont des nanoparticules distribuées de manière homogène dans le fluide de protection contre la glace (110).

10. Système (100) selon la revendication 1, dans lequel le capteur (104) comprend :
des paires de contacts électriques (608) ayant leur circuit fermé lorsque le fluide de protection contre la glace établit un trajet électrique entre elles.

11. Système (100) selon la revendication 10, dans lequel les paires de contacts électriques (608) mesurent une impédance et/ou une tension entre deux points de contact (612) sur la surface sujette à la formation de glace pour différencier le fluide de protection contre la glace de l'eau s'écoulant sur la surface sujette à la formation de glace.

12. Système selon la revendication 11, dans lequel le fluide de protection contre la glace (110) comprend des particules métalliques (400) qui augmentent la conductivité du fluide de protection contre la glace.

13. Système (100) selon la revendication 1, comprenant en outre un système d'alerte activé lorsque le système de dégivrage est activé et le capteur ne détecte pas le fluide de protection contre la glace à un niveau cible dans une période de temps spécifiée, de façon à ce qu'une condition de vol sans givrage puisse être trouvée.

14. Système (100) selon la revendication 1, dans lequel :
le système de dégivrage (106) comprend un débitmètre (718) indiquant l'écoulement du fluide de protection contre la glace, et
le capteur comprend des éléments de détection (412) distribués sur la surface sujette à la formation de glace de telle sorte qu'un ou plusieurs parmi ce qui suit puissent être détectés :
un blocage dans l'écoulement et le débit du fluide de protection contre la glace,
un suintement du fluide de protection contre la glace à partir de différentes sections d'un panneau poreux (706) et sur la surface sujette à la formation de glace,
une fuite non souhaitée d'un fluide de protection contre la glace à partir du panneau poreux (706), et
un fonctionnement du débitmètre.

15. Système (100) selon la revendication 14, comprenant en outre un éjecteur (712) évacuant un fluide de protection contre la glace à partir du panneau poreux à l'aide de l'air de prélèvement réacteur lorsque la fuite non souhaitée est détectée.

16. Système (100) selon la revendication 1, dans lequel la surface sujette à la formation de glace est un bord d'attaque (112) d'une aile (308), d'une queue (224), ou d'une entrée d'air moteur (214) sur l'aéronef.

17. Système (100) selon la revendication 1, dans lequel le capteur comprend des signaux RADAR, hyperfréquences, ou à ondes millimétriques.

18. Procédé de dégivrage d'une surface sujette à la formation de glace (102) d'un aéronef (204), comprenant :
la détection d'une présence d'un fluide de protection contre la glace (110) sur une surface sujette à la formation de glace (102) d'un aéronef, dans lequel la détection utilise une détection et une télémétrie par la lumière ; et
la vérification d'un fonctionnement d'un système de dégivrage sur la surface sujette à la formation de glace sur la base d'une entrée à partir de la détection.

19. Procédé selon la revendication 18, dans lequel la détection détecte une conductivité et/ou une propriété magnétique du fluide de protection contre la glace pour indiquer la présence du fluide de protection contre la glace.
